# EUROPÄISCHE PATENTSCHRIFT

(11) **EP 1 895 315 B1**
(45) Veröffentlichungstag und Bekanntmachung des Hinweises auf die Patenterteilung: **07.11.2018**
(21) Anmeldenummer: 07016519.6
(22) Anmeldetag: 23.08.2007
(51) Int. Cl.: G01R 33/38, G01R 33/3815, H01F 6/00

(54) **Split Coil Magnetanordnung mit verbessertem mechanischen Aufbau**
Split coil magnet assembly with an improved mechanical structure
Arrangement magnétique de bobine séparée doté d'une construction mécanique améliorée

(30) Priorität: 30.08.2006 DE 102006040687
(43) Veröffentlichungstag der Anmeldung: 05.03.2008
(73) Patentinhaber: Bruker BioSpin AG, 8117 Fällanden (CH)
(72) Erfinder: Gilardi, Raffaele, 6500 Bellinzona (CH); Schneider, Stefan, 4852 Rothrist (CH); Schauwecker, Robert, 8004 Zürich (CH); Bovier, Pierre-Alain, 8050 Zürich (CH)
(74) Vertreter: Kohler Schmid Möbus Patentanwälte

(56) Entgegenhaltungen:
- EP-A2- 0 971 240
- DE-A1- 19 606 699
- GB-A- 2 247 355
- JP-A- 2001 230 114
- JP-A- 2006 141 613
- US-A- 5 291 169
- US-A- 5 448 214
- US-A- 5 650 903
- US-A- 6 150 912
- US-B2- 6 717 408
- CLAUDET G ET AL: "A 10 tesla cryomagnetic system for neutron scattering experiments" CRYOGENICS, ELSEVIER, KIDLINGTON, GB LNKD- DOI:10.1016/0011-2275(81)90214-9, Bd. 21, Nr. 12, 1. Dezember 1981 (1981-12-01), Seiten 711-714, XP024048262 ISSN: 0011-2275 [gefunden am 1981-12-01]

## Beschreibung

Die Erfindung betrifft eine Magnetanordnung mit einem Magnetspulensystem zur Erzeugung eines Magnetfeldes in Richtung einer z-Achse in einem auf der z-Achse um z=0 angeordneten Arbeitsvolumen mit zwei um die z-Achse positionierten Behältern und mit zwei Spulensystemen, die in je einem der Behälter angeordnet sind, wobei die Behälter je eines der beiden Spulensysteme vollständig umschliessen und mechanisch durch einen Spalt axial bezüglich der z-Achse voneinander getrennt sind, wobei die Spulensysteme jeweils ein erstes Teilspulensystem umfassen und mindestens eines der Spulensysteme ein zweites Teilspulensystem umfasst, wobei jedes Teilspulensystem mindestens einen Spulenkörper und mindestens ein felderzeugendes Wickelpaket aufweist, wobei die ersten Teilspulensysteme im Betriebszustand je einer in axialer Richtung zum Spalt hinziehenden resultierenden magnetischen Kraft ausgesetzt sind, und wobei die zweiten Teilspulensysteme im Betriebszustand je einer in axialer Richtung vom Spalt forttreibenden resultierenden magnetischen Kraft ausgesetzt sind, wobei diese magnetischen Kräfte mindestens teilweise mechanisch auf die Behälter übertragen werden, und mit mindestens einer auf Druck belastbaren mechanischen Struktur, welche im Spalt angeordnet ist und mindestens einen Teil der hinziehenden magnetischen Kräfte aufnimmt.

Eine derartige Anordnung ist bekannt aus [1].

Das Einsatzgebiet solcher Magnetanordnungen umfasst verschiedene Anwendungsfelder. In Experimenten zur Untersuchung von Materialeigenschaften in einem Magnetfeld mittels Neutronen- und Röntgenstrahlen ermöglicht ein kleiner Spalt (typischerweise kleiner als 5 cm am Magnetzentrum) zwischen den zwei Spulensystemen einen direkten Zugang auf die Probe für den Neutronen- bzw. Röntgenstrahl. Die Probe wird durch eine Bohrung entlang der Achse der Magnetanordnung im Arbeitsvolumen positioniert und wird vom Neutronen- bzw. Röntgenstrahl radial durch den Spalt beleuchtet. Der Neutronen- bzw. Röntgenstrahl wird nach dem Streuprozess mit der Probe am Rand des Magnetsystems detektiert. Damit möglichst viele Neutronen bzw. Photonen auf die Probe und in die Detektoren kommen, muss die Größe der mechanischen Struktur, welche im Spalt die magnetischen Kräfte zwischen den Spulensystemen aufnimmt, insbesondere im Bereich des Neutronen- bzw. Röntgenstrahls, minimiert werden und aus geeignetem Material bestehen. In Magneten für Neutronenstreuung werden oft dünne Aluminium-Ringe im Spalt verwendet, da Aluminium für Neutronen recht transparent ist (typisch 3-4% Verlust pro 1 cm Aluminium). Es ist darüber hinaus bekannt, die Struktur im Spalt als Keile oder Säulen auszubilden. Zudem kann der freie Raum im Spalt im Betriebszustand evakuiert werden, um unerwünschte Streuungen zwischen Neutronen- bzw. Röntgenstrahl und Flüssigkeiten oder Gas zu verhindern.

Aus [2] ist eine Magnetanordnung bekannt, deren Magnetspulensystem zwei unterschiedliche supraleitende Spulensysteme umfasst, die in zwei mechanisch durch einen Spalt axial getrennten, vakuumdichten und mit flüssigem Helium gefüllten Behältern positioniert sind. Der Spalt beträgt 10 mm am Magnetzentrum und nimmt radial mit einem Öffnungswinkel von + 10° und - 5° zu, um den Öffnungsquerschnitt für den Strahl zu vergrößern. Diese Magnetanordnung besteht ausschließlich aus Spulen, welche in axialer Richtung zum Spalt hinziehenden magnetischen Kräften ausgesetzt sind. Dies gilt auch für alle anderen bisher realisierten Magnetanordnungen für Neutronen- und Röntgenstreuung. Jede Spule wird mit einem eigenen Schutzelement niederohmiger Widerstand) gegen Überhitzung und hohe elektrische Spannungen im Falle eines Zusammenbruchs der Supraleitung (Quench) während des Betriebs geschützt. Um das vertikale magnetische Feld von 10 Tesla effizient zu erzeugen, sind die Behälter am Spalt möglichst dünnwandig (3mm Stahl). Der kleine Abstand zwischen den zwei Spulensystemen bewirkt aber, dass die anziehenden axialen Kräfte zwischen den zwei Spulensystemen besonders groß sind (etwa 250kN). Im evakuierten Spalt zwischen den Behältern werden deshalb dünne konzentrische Aluminium-Ringe eingelegt, welche die anziehenden axialen magnetischen Kräfte zwischen den zwei Spulensystemen im Betriebszustand aufnehmen und eine Verformung der dünnen Behälter verhindern. Bei diesem mechanischen Aufbau gibt es keine Nahtstelle zwischen Aluminium und Stahl (oder anderen Materialien), so dass keine Probleme mit den thermischen Ausdehnungen beim Abkühlen des Systems entstehen. Die zwei Behälter werden mit drei Rohren aus Stahl zusammengehalten, welche auch für die Kühlflüssigkeiten und elektrischen Verbindungen verwendet werden. Manchmal wird ein zusätzlicher Aluminium-Ring im Spalt an die zwei Behälter geschraubt, um die zwei Behälter zusammenzuhalten, wenn im ungeladenen Zustand keine magnetischen Kräfte vorhanden sind, welche die Gewichtskräfte auf die Behälter aufnehmen.

Eine ähnliche mechanische Struktur im Spalt einer Split Coil Magnetanordnung ist auch bekannt aus [3], wobei diese Struktur aus C-förmigen Aluminium-Ringen und Distanzscheiben besteht.

Aus [8] ist eine Magnetanordnung in offener Architektur mit zwei Spulensystemen bekannt, die jeweils in einem Behälter angeordnet sind. Die Behälter sind durch einen Spalt getrennt. Die Spulensysteme umfassen jeweils zwei Teilspulensysteme mit Wickelpaketen und Spulenkörpern. Darüber hinaus wird eine mechanische Struktur offenbart, die im Spalt zwischen den Behältern angeordnet ist.

Aus [10] ist eine Magnetanordnung in offener Architektur mit zwei Spulensystemen bekannt, die jeweils in einem Behälter angeordnet sind. Die Behälter sind durch einen Spalt getrennt, in welchem ein Verbindungselement die Behälter gegeneinander abstützt. Zusätzlich ist ein Verbindungselement vorhanden, welches außerhalb der Behälter angeordnete Gradientenspulen mit einem der Behälter mechanisch verbindet.

Solche mechanischen Strukturen im Spalt können effizient die anziehenden Kräfte zwischen den zwei Spulensystemen aufnehmen und eine Verformung der Behälter verhindern. Allerdings haben derartige bekannte Vorrichtungen den Nachteil, dass ausschließlich zum Spalt hinziehende magnetische Kräfte aufgenommen werden können.

In [4], [5] und [9] wird eine Magnetanordnung beschrieben, welche zwei durch einen Spalt getrennte Spulensysteme mit je zwei Teilspulensystemen umfasst, wobei die ersten Teilspulensysteme in axialer Richtung zum Spalt hinziehenden und die zweiten Teilspulensysteme in axialer Richtung vom Spalt forttreibenden magnetischen Kräften ausgesetzt sind. Derartige Systeme sind auch bekannt aus [6], [7], [1]. Ein Einsatzgebiet derartiger Anordnungen sind offene supraleitende Magneten, die zur Erzeugung eines Magnetfeldes (von typischerweise 1 Tesla) als Teil eines Systems zur Magnet-Resonanz Bildgebung (MRI) verwendet werden. Offene Magnete sollen zwischen den Spulensystemen einen seitlichen Zugang zum Patienten während der MRI Bildgebung gestatten. Der Abstand zwischen den zwei Spulensystemen ist typischerweise größer als 50 cm. Üblicherweise werden zum Auffangen der anziehenden Kräfte nur wenige Stangen im Spalt zwischen den zwei Spulensystemen positioniert.

Die Magnetanordnung aus [4] besteht aus zwei identischen, supraleitenden Spulensystemen, die in zwei mechanisch durch einen Spalt axial getrennten Behältern positioniert sind, welche aktiv gekühlt werden (ohne die Verwendung von kryogenen Flüssigkeiten). Jedes Spulensystem umfasst drei Spulen. Auf zwei Spulen wirkt im Betriebszustand eine in axialer Richtung zum Spalt hinziehende magnetische Kraft. Auf die dritten Spulen wirkt hingegen eine in axialer Richtung vom Spalt forttreibende magnetische Kraft. Die resultierende Kraft zwischen den zwei Spulensystemen ist im Betriebszustand anziehend (765 kN). Die drei Spulen eines Spulensystems sind durch eine starre Struktur aus Stahl miteinander verbunden. Im Spalt sind vier Stangen vorhanden, welche die zwei Spulensysteme trennen und die resultierende anziehende Kraft abstützen. Jede Spule wird mit einem eigenen Schutzelement (antiparallele Diodenpaare) gegen Überhitzung und hohe elektrische Spannungen im Falle eines Quenchs geschützt.

In der Anordnung von [6] sind zwei axial getrennte supraleitende Spulensysteme beschrieben, wobei jedes Spulensystem zwei Teilspulensysteme umfasst, welche elektrische Ströme in entgegensetzten Richtungen führen und welche magnetischen Kräften in axial entgegengesetzten Richtungen ausgesetzt sind. Die zwei Teilspulensysteme sind jeweils durch eine starre Struktur verbunden, welche die magnetischen Kräfte aufnimmt und so die Teilspulensysteme zusammenhält. Die zwei Spulensysteme sind durch vier tragende Stangen zusammen verschraubt, welche die resultierende anziehende magnetische Kraft aufnehmen und die zwei Spulensysteme getrennt halten.

In der Anordnung von [7] gibt es zusätzlich zu der starren Struktur innerhalb der Behälter eine Vielzahl von Streben, welche die hinziehenden und forttreibenden magnetischen Kräfte der verschiedenen Teilspulensysteme aufnehmen und eine Verformung der Behälter verhindern.

In der Anordnung von [9] wird eine offene MRI-Anordnung mit zwei Hauptfeld-Spulensystemen offenbart, die mittels mehrerer Verstrebungen auf Abstand gehalten werden. Zu jedem Hauptfeld-Spulensystem ist ein Abschirmspulensystem vorgesehen, das mittels weiterer Verstrebungen mit dem dazugehörigen Hauptfeld-Spulensystem verbunden ist.

In der Anordnung von [1] gibt es zwei tragende Verbindungsstrukturen zwischen den zwei Spulensystemen. Auch bei dieser Anordnung sind innerhalb des Behälters, in dem die Spulensysteme angeordnet sind, starre Strukturen vorgesehen, welche die hinziehenden und forttreibenden magnetischen Kräfte der verschiedenen Teilspulensysteme aufnehmen. Die resultierende Kraft zwischen den zwei Spulensystemen ist anziehend, und wird von den auf Druck belastbaren Verbindungsstrukturen aufgenommen. Darüber hinaus sind an einer Seite radial außerhalb der Behälter Transportsicherungsstäbe vorgesehen, die Vibrationen und Torsionen des Magnetsystems entgegenwirken.
Solche mechanischen Strukturen im Spalt sind geeignet für offene MRI Systeme, wobei der Abstand zwischen den zwei Spulensystemen groß ist. Um einen ausreichenden seitlichen Zugang zum Patienten zu gewährleisten, muss die Verbindungsstruktur zwischen den zwei Spulensystemen möglichst Raum sparend ausgestattet sein. Deshalb sind bei den bekannten Anordnungen die verschiedenen Teilspulensysteme in jedem Spulensystem durch eine starre Struktur miteinander verbunden, so dass nur die resultierende magnetische Kraft zwischen den Spulensystemen durch möglichst wenige und Raum sparende Verbindungsstrukturen im Spalt aufgenommen werden muss. Allerdings haben derartige bekannte Verbindungsstrukturen den Nachteil, dass die hierzu benötigten starren Strukturen zur Verbindung innerhalb der Behälter Platz in Anspruch nehmen, der jedoch auch für Kühlflüssigkeiten benötigt wird. Die Behälter müssen daher entsprechend groß dimensioniert werden.
Es ist Aufgabe der vorliegenden Erfindung, eine Magnetanordnung vorzuschlagen, bei der die magnetischen Kräfte beherrscht werden können und gleichzeitig ein kostengünstiger, einfacher, Platz und Gewicht sparender Aufbau realisiert werden kann.
Diese Aufgabe wird erfindungsgemäß durch eine Magnetanordnung gemäß Anspruch 1 gelöst.

Erfindungsgemäß ist im selben Spalt radial, d.h. in Richtung senkrecht zur z-Achse, innerhalb der Abmessungen beider Behälter zusätzlich zu der auf Druck belastbaren mechanischen Struktur eine weitere mechanische Struktur vorgesehen, die in z-Richtung mechanisch auf Zug belastbar ist und mindestens einen Teil der in axialer Richtung forttreibenden magnetischen Kräfte aufnimmt, wobei die weitere mechanische Struktur mit den Behältern verbunden ist und diese zusammenhält.

Während bei den bekannten Anordnungen die Teilspulensysteme innerhalb eines Behälters mittels einer starren Struktur verbunden sind und somit auf die Spulensysteme und entsprechend auch auf die die Spulensysteme enthaltenden Behälter lediglich eine resultierende, zum Spalt hinziehende Kraft wirkt, sind die Spulensysteme und die entsprechenden Behälter der erfindungsgemäßen Magnetanordnung lokal sowohl zum Spalt hinziehenden als auch vom Spalt forttreibenden Kräften ausgesetzt. Die entscheidende Idee der Erfindung ist, im Spalt sowohl auf Druck als auch auf Zug belastbare Strukturen vorzusehen. Diese Anordnung ermöglicht es, die magnetischen Kräfte dort aufzunehmen, wo sie angreifen. Der Vorteil der erfindungsgemäßen Anordnung besteht darin, dass man innerhalb der Behälter keine starre Struktur zur Verbindung der Teilspulensysteme miteinander braucht, um die magnetischen Kräfte in den Spulensystemen aufzunehmen. Die erfindungsgemäße mechanische Struktur wird daher keinem aufgrund der magnetischen Kräfte innerhalb der Teilspulensysteme wirkenden Drehmoment ausgesetzt, sondern nur auf Druck oder Zug belastet. Auf die mechanische Struktur wirkende Biegekräfte können somit stark reduziert oder ganz eliminiert werden. Die erfindungsgemäße Anordnung kommt daher mit weniger Material für die mechanische Struktur zur Aufnahme der magnetischen Kräfte aus. Zudem können die Behälter aufgrund der nicht mehr notwendigen starren Strukturen innerhalb der Behälter kleiner dimensioniert werden. Die erfindungsgemäße Magnetanordnung ist dadurch Platz sparend. Insbesondere kann die Distanz zwischen Magnetzentrum und Kryostatenboden klein gehalten werden.

Vorzugsweise ist der größte Winkelbereich um die z-Achse ohne Kontaktstellen zwischen der mechanische auf Zug belastbaren Struktur und den beiden Behältern kleiner oder gleich 180°. Die weitere mechanische Struktur ist demnach in jedem Halbraum um die z-Achse mit den Behältern kontaktiert. Die weitere mechanische Struktur kann dabei auch mehrere einzelne Elemente umfassen, die unabhängig voneinander montiert werden können.

Besonders bevorzugt ist eine Ausführungsform, bei der die in z-Richtung mechanisch auf Zug belastbare Struktur mit den Behältern durch Stoffschluss verbunden ist. Eine solche Bauform erlaubt eine kompakte Konstruktion und die Übertragung von großen Kräften.

Alternativ dazu kann es auch vorteilhaft sein, wenn die in z-Richtung mechanisch auf Zug belastbare Struktur mit den Behältern formschlüssig verbunden ist. Eine solche Anordnung erlaubt eine einfache Montage und eine zerstörungsfreie Demontage der Struktur.

Besonders vorteilhaft ist es, wenn die Spulenkörper der ersten Teilspulensysteme und der zweiten Teilspulensysteme, die in z-Richtung mechanisch auf Zug belastbare Struktur und die Behälter aus demselben Material gefertigt sind. Ein großer Vorteil bei der Verwendung eines einheitlichen Materials ist die einfache Herstellbarkeit von Verbindungen mittels stoffschlüssiger Verfahren. Zudem ist ein einheitliches Material von Vorteil, wenn sich die Betriebstemperatur von der Temperatur bei der mechanischen Montage unterscheidet, wie das zum Beispiel bei supraleitenden Spulen mit tiefer Betriebstemperatur der Fall ist. Verschiebungen aufgrund von Verwendung von Materialien mit unterschiedlichen thermischen Ausdehnungskoeffizienten und somit unerwünschte Spannungen in den Kontaktbereichen können somit vermieden werden.

Es kann jedoch auch vorteilhaft sein, wenn die Spulenkörper der ersten Teilspulensysteme und der zweiten Teilspulensysteme, die in z-Richtung mechanisch auf Zug belastbare Struktur und die Behälter aus mindestens zwei verschiedenen Materialien gefertigt sind. In einer solchen Anordnung kann für jedes Element das Material gewählt werden, welches in Bezug auf die physikalischen Eigenschaften optimal ist.

Eine Weiterbildung dieser Ausführungsform sieht vor, dass der Absolutbetrag der Differenz der relativen thermischen Längenänderungen mindestens zweier der verschiedenen Materialien nach Erreichen einer Betriebstemperatur, welche sich von der Temperatur bei der mechanischen Montage der Magnetanordnung unterscheidet, kleiner als 0.1% ist. Eine solche Materialwahl verhindert einerseits das Auftreten großer Kräfte, ausgelöst durch thermische Verschiebungen im Kontaktbereich von Materialen unterschiedlicher Temperaturausdehnungen, andererseits können die Eigenschaften der Materialien der einzelnen Elemente zumindest innerhalb dieser Grenzen den Anforderungen angepasst werden.

Bei einer vorteilhaften Weiterbildung umfasst die in z-Richtung mechanisch auf Zug belastbare Struktur mehrere Segmente, die um die z-Achse angeordnet sind, wobei die Segmente azimutal voneinander beabstandet sind. Zwischen den Segmenten befinden sich Freiräume, vorzugsweise Schlitze in radialer Richtung, welche die Funktion einer Dehnungsfuge haben. Die Grenzflächen der Strukturen zu diesen Freiräumen liegen jeweils vorzugsweise in oder parallel zu einer Ebene, welche die z-Achse beinhaltet. Diese Freiräume können aufklaffen oder sich schließen, sobald die an einen Freiraum angrenzenden Teile der in z-Richtung mechanisch auf Zug belastbaren Struktur Verschiebungen senkrecht zur Richtung der z-Achse erfahren. Mit einer solchen Anordnung können Kräfte vermieden werden, welche sonst an den Grenzflächen zwischen der mechanisch auf Zug belastbaren Struktur und den Behältern aufgrund ungleicher thermischer Verschiebungen auftreten würden.

Eine weitere Möglichkeit, mit der derartige Kräfte vermieden werden können, stellt eine weitere Ausführungsform der erfindungsgemäßen Magnetanordnung dar, bei der die mechanisch auf Zug belastbare Struktur mindestens einen ersten, nicht deformierbaren Teilbereich und mindestens einen weiteren Teilbereich, der in einer Richtung senkrecht zur z-Achse deformierbar ist, umfasst. Die weiteren Teilbereiche weisen eine gegenüber den ersten Teilbereichen reduzierte Federkonstante auf, so dass die Struktur in den weiteren Teilbereichen tangential deformiert werden kann, sobald auf die Struktur eine senkrecht zur Richtung der z-Achse gerichtete Kraft wirkt. Eine derartige Struktur kann einteilig hergestellt werden.

Bei einer speziellen Ausführungsform ist in mindestens einem der Behälter mindestens eine zusätzliche auf Biegung belastbare Struktur mit dem ersten Teilspulensystem und dem zweiten Teilspulensystem mechanisch verbunden und nimmt mindestens einen Teil der hinziehenden und der forttreibenden magnetischen Kräfte auf. Das Volumen der mechanisch auf Zug belastbaren Struktur im Spalt kann somit reduziert werden. Dies ist insbesondere dann vorteilhaft, wenn die Materialmenge im Spalt ein Hindernis für Strahlung, welche den Spalt passieren soll, darstellt.

Vorzugsweise ist mindestens eines der zweiten Teilspulensysteme radial außerhalb des entsprechenden, d.h. sich im selben Behälter befindlichen, ersten Teilspulensystems angebracht, und kompensiert im Betriebszustand das magnetische Dipolmoment der beiden ersten Teilspulensysteme zu mindestens 50%. Das zweite Teilspulensystem wirkt somit als aktive Streufeldabschirmung für das erste Teilspulensystem. Vorzugsweise ist in jedem der beiden Behälter je ein zweites Teilspulensystem radial außerhalb des ersten Teilspulensystems angebracht, welche zusammen im Betriebszustand das magnetische Dipolmoment der ersten Teilspulensysteme zu mindestens 50% kompensieren. In diesem Fall können (müssen aber nicht) die zwei Spulensysteme auch einzeln aktiv abgeschirmt werden, d.h. dass jedes zweite Teilspulensystem das magnetische Dipolmoment des zugehörigen ersten Teilspulensystems zu mindestens 50% kompensiert.

Bei einer weiteren vorteilhaften Ausführungsform sind die durch den Spalt getrennten Spulensysteme mechanisch und geometrisch gleich gebaut und symmetrisch zur Ebene, welche senkrecht zur z-Achse liegt und diese auf der Höhe z=0 schneidet, in den Behältern positioniert. Wenn die Spulen, die geometrisch gleich gebaut sind, jeweils den gleichen Strom tragen, ist die Feldverteilung im Arbeitsvolumen und im Spalt symmetrisch zur Ebene z=0. Eine asymmetrische Feldverteilung kann durch eine unterschiedliche Bestromung der zueinander äquivalenten Spulen erreicht werden. Durch einen solchen symmetrischen Aufbau wird die Teilevielfalt reduziert und somit der Herstellungsprozess vereinfacht.

Eine alternative Ausführungsform sieht vor, dass die durch den Spalt getrennten Spulensysteme mechanisch und geometrisch unterschiedlich aufgebaut und/oder asymmetrisch zur Ebene, welche senkrecht zur z-Achse liegt und diese auf der Höhe z=0 schneidet, in den Behältern positioniert sind. In einer solchen Anordnung ist die Feldverteilung im Arbeitsvolumen und im Spalt nicht symmetrisch zur Ebene z=0, wenn alle Spulen in Serie geschaltet sind und einen einzigen Strompfad bilden. Somit können auf einfache Weise insbesondere Feldnulldurchgänge in der Nähe der Ebene z=0 vermieden werden, die bei Neutronenstreuungsexperimenten mit polarisierten Neutronen unerwünscht sind, da polarisierte Neutronen dort ihre Spinausrichtung verlieren würden.

Vorzugsweise ist der Innenradius mindestens eines der zweiten Teilspulensysteme größer als 1.3-mal der Außenradius eines der ersten Teilspulensysteme. Somit können die auf die zweiten Teilspulensysteme wirkenden magnetischen Kräfte klein gehalten werden.

Darüber hinaus ist es von Vorteil, wenn die Distanz zwischen dem Wickelpaket eines der zweiten Teilspulensysteme und dem Spalt kleiner als 12 mm ist. Wenn die Wickelpakete der zweiten Teilspulensysteme axial so nah wie möglich am Spalt positioniert sind, sind die auf sie wirkenden magnetischen Kräfte kleiner als wenn die zweiten Teilspulensysteme axial weit weg vom Spalt angeordnet wären.

Die erfindungsgemäße Magnetanordnung kann prinzipiell mit normalleitenden Spulen realisiert werden. Jedoch wird bei normalleitenden Magnetanordnungen eine große Menge an Leitermaterial benötigt, um die benötigte Feldstärke zu erzeugen. Es ist daher vorteilhaft, wenn ein oder mehrere Teilspulensysteme zumindest teilweise supraleitend sind. Mit supraleitenden Spulen können sehr starke Felder erzeugt werden. Jedoch sind auch die magnetischen Kräfte zwischen den Teilspulensystemen groß. Daher kommen die Vorteile der erfindungsgemäßen weiteren mechanischen Struktur zur Aufnahme dieser Kräfte in einer supraleitenden Magnetanordnung besonders gut zur Geltung.

Bei der Verwendung von supraleitenden Teilspulensystemen ist es von Vorteil, wenn eines der zweiten Teilspulensysteme oder Teile davon und eines der ersten Teilspulensysteme oder Teile davon als Schutzabschnitt zusammen in Serie geschaltet sind, wobei der Schutzabschnitt parallel zu einem gemeinsamen Schutzelement geschaltet ist. Die Schutzabschnitte schützen die supraleitenden Teilspulensysteme im Fall eines Quenchs, so dass ein zu starkes Anwachsen der magnetischen Kräfte auf die supraleitenden Spulen im Quenchfall verhindert wird.

Eine vorteilhafte Weiterbildung dieser Ausführungsform sieht vor, dass im Betriebszustand in mindestens einem der Schutzabschnitte die magnetischen Dipolmomente der Teile des zweiten Teilspulensystems die magnetischen Dipolmomente der Teile des ersten Teilspulensystems zu mindestens 50% kompensieren. Dies ermöglicht auch im Quenchfall eine starke Unterdrückung unerwünschter Streufelder.

Besonders vorteilhaft ist es, wenn eines der zweiten Teilspulensysteme oder Teile davon und eines der ersten Teilspulensysteme oder Teile davon innerhalb eines supraleitenden Strompfads zusammen in Serie und parallel zu einem supraleitenden Schalter geschaltet sind. In einer solchen Anordnung kann eine asymmetrische Feldverteilung im Arbeitsvolumen und im Spalt bezüglich der Ebene z=0 realisiert werden, indem man die Strompfade mit unterschiedlichen Strömen lädt. Gleichzeitig kann verhindert werden, dass die magnetischen Kräfte zu stark anwachsen, wenn die Strompfade unterschiedliche Ströme tragen.

Bei einer Weiterbildung dieser besonders bevorzugten Ausführungsform kompensieren im Betriebszustand in mindestens einem der supraleitenden Strompfade die magnetischen Dipolmomente der Teile des zweiten Teilspulensystems die magnetischen Dipolmomente der Teile des ersten Teilspulensystems zu mindestens 50%. Somit können Streufelder auch dann stark unterdrückt werden, wenn die Strompfade unterschiedliche Ströme tragen.

Vorzugsweise sind die zwei Behälter mit Kühlflüssigkeiten gefüllt. Da aufgrund der erfindungsgemäßen weiteren mechanischen Struktur auf eine starre Struktur innerhalb der Behälter zur Verbindung der Teilspulensysteme miteinander verzichtet werden kann, steht mehr Volumen für Kühlflüssigkeiten zur Kühlung der Teilspulensysteme zur Verfügung.
Darüber hinaus ist es vorteilhaft, wenn eine Vorrichtung zur aktiven Kühlung der Behälter vorgesehen ist. Die Kühlflüssigkeit muss dann nicht so oft oder gar nicht nachgefüllt werden. Bei der erfindungsgemäßen Anordnung kann darüber hinaus ein Kryokühler mit einer geringeren Leistung verwendet werden als bei den aus dem Stand der Technik bekannten Vorrichtungen, da aufgrund der fehlenden starren mechanischen Struktur innerhalb der Behälter weniger Masse auf die Betriebstemperatur der Magnetanordnung gekühlt werden muss.
Die erfindungsgemäße Magnetanordnung ist vorzugsweise Teil einer Apparatur für Neutronenstreuung, einer Apparatur für Röntgenstreuung oder einer MRI-Apparatur. Die erfindungsgemäße mechanische Struktur im Spalt erlaubt es, auch Spulenkonfigurationen zu bauen, bei welchen die Kräfte auf die Teilspulensysteme besonders hoch werden. Durch diese Kräfte wurden der Auslegung der Magnetanordnung bisher enge Grenzen gesetzt. Durch die erfindungsgemäße Anordnung werden insbesondere stärkere Magnetfelder im Arbeitsvolumen und effizientere aktive Streufeldabschirmungen ermöglicht, was in den genannten Einsatzgebieten von besonderem Nutzen ist.
Weitere Vorteile der Erfindung ergeben sich aus der Beschreibung und der Zeichnung. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1: einen schematischen Vertikalschnitt durch eine radiale Hälfte einer erfindungsgemäßen Magnetanordnung;
- Fig. 2: einen schematischen Vertikalschnitt durch eine radiale Hälfte einer erfindungsgemäßen Magnetanordnung, wobei die Abmessungen der Wickelpakete gezeigt sind;
- Fig. 3: eine erfindungsgemäße Ausführung einer in z-Richtung mechanisch auf Zug belastbaren Struktur;
- Fig. 4: eine weitere erfindungsgemäße Ausführung einer in z-Richtung mechanisch auf Zug belastbaren Struktur;
- Fig. 5: ein Verdrahtungsschema einer erfindungsgemäßen Magnetanordnung;
- Fig. 6: ein besonders vorteilhaftes Verdrahtungsschema einer erfindungsgemäßen Magnetanordnung;
- Fig. 7: einen schematischen Vertikalschnitt durch eine radiale Hälfte einer weiteren erfindungsgemäßen Magnetanordnung; und
- Fig. 8: einen schematischen Vertikalschnitt durch eine radiale Hälfte einer Magnetanordnung nach dem Stand der Technik.

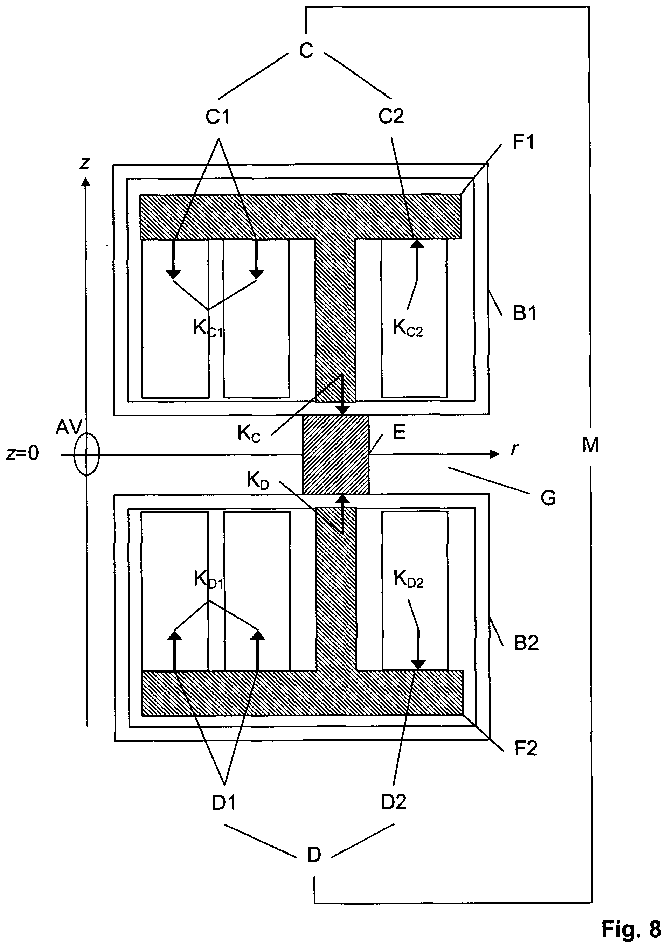

**Fig. 8** zeigt eine Magnetanordnung nach dem Stand der Technik, welche um ein Arbeitsvolumen **AV** angeordnet ist und ein Magnetspulensystem **M** mit zwei Spulensystemen **C, D** zur Erzeugung eines Magnetfeldes in Richtung einer z-Achse umfasst. Die zwei Spulensysteme C, D sind in mechanisch durch einen Spalt **G** axial getrennten Behältern **B1, B2** positioniert. Die Spulensysteme C, D umfassen jeweils erste Teilspulensysteme **C1, D1** und jeweils ein zweites Teilspulensystem **C2**, **D2**. Die ersten Teilspulensysteme C1, D1 sind gleich polarisiert und in axialer Richtung zum Spalt G hinziehenden magnetischen Kräften **K_{C1}**, **K_{D1}** ausgesetzt. Das jeweilige zweite Teilspulensystem C2, D2 ist radial außerhalb des entsprechenden ersten Teilspulensystems C1, D1 angebracht und entgegengesetzt zum ersten Teilspulensystem C1, D1 polarisiert. Die zweiten Teilspulensysteme C2, D2 dienen beispielsweise als Kompensationsspulen für das Streufeld der Magnetanordnung. Bei dieser Anordnung sind die zweiten Teilspulensysteme C2, D2 in axialer Richtung vom Spalt G forttreibenden magnetischen Kräften **K_{C2}**, **K_{D2}** ausgesetzt. Die ersten und zweiten Teilspulensysteme C1, C2, D1, D2 sind durch eine starre Struktur **F1**, **F2** innerhalb der Behälter B1, B2 verbunden, welche die magnetischen Kräfte K_{C1}, K_{C2}, K_{D1}, K_{D2} aufnimmt. Im Spalt G ist eine mechanische Struktur **E** vorhanden, welche die resultierenden hinziehenden magnetischen Kräfte K_{C}, K_{D} zwischen den Behältern B1, B2 aufnimmt. Die durch den Spalt G getrennten Spulensysteme C, D sind mechanisch und geometrisch gleich gebaut (C1 = D1 und C2 = D2) und symmetrisch zur Ebene z=0 angeordnet.

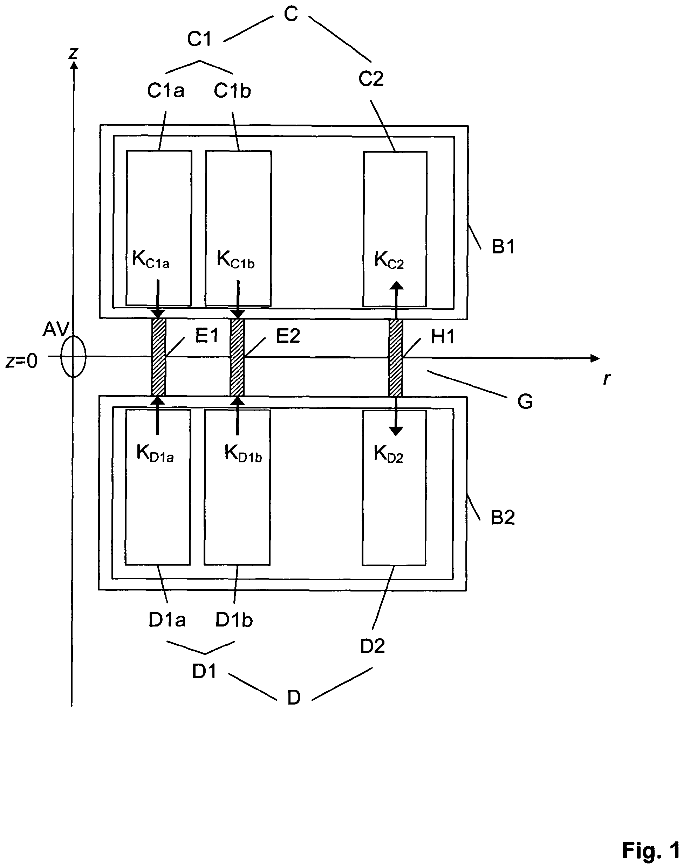

**Fig. 1** zeigt eine erfindungsgemäße Magnetanordnung, bei der auf die starren Strukturen F1, F2 in den Behältern B1, B2 verzichtet wurde. Die zwischen den Spulensystemen C, D auftretenden axialen magnetischen Kräfte werden hier auf eine andere Weise beherrscht. Die ersten Teilspulensysteme C1, D1 umfassen je zwei Teilspulen **C1a**, **C1b**, **D1a**, **D1b**. Im Spalt G sind zwei auf Druck belastbare mechanische Strukturen **E1**, **E2** vorgesehen, welche die zum Spalt G hinziehenden magnetischen Kräfte K_{C1a} und K_{D1a} bzw. K_{C1b} und K_{D1b} aufnehmen. Darüber hinaus ist zwischen den beiden Behältern B1, B2 eine auf Zug belastbare Struktur **H1** angeordnet, welche die vom Spalt G forttreibenden magnetischen Kräfte K_{C2}, K_{D2} aufnimmt und gleichzeitig die zwei Behälter B1, B2 zusammenhält. Die auf Zug belastbare Struktur H1 kann mit den Behältern B1, B2 durch Stoffschluss oder formschlüssig verbunden sein, während die auf Druck belastbaren mechanischen Strukturen E1, E2 vorzugsweise im Spalt zwischen den Behältern eingelegt und nicht notwendigerweise durch Stoffschluss oder formschlüssig mit diesen verbunden sind.

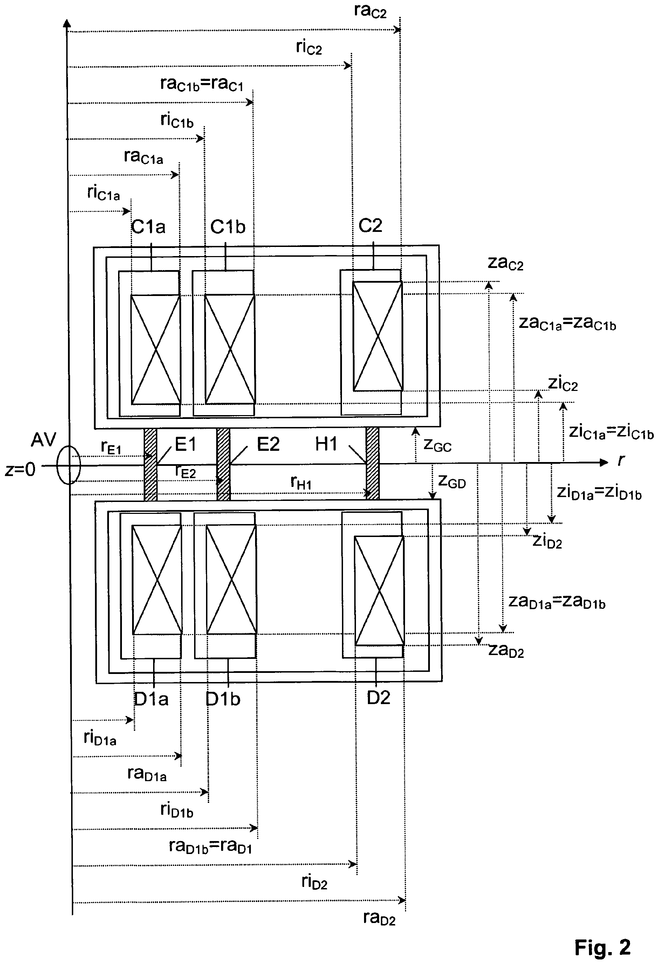

**Fig. 2** zeigt die erfindungsgemäße Magnetanordnung mit den Abmessungen der Wickelpakete. Die Größe **riₖⱼ** beziehungsweise **raₖⱼ** (k=C, D; j=1a, 1b, 2) bezeichnet den Innen- beziehungsweise Außenradius des Wickelpakets der Spule kj. Die Größe **ziₖⱼ** beziehungsweise **zaₖⱼ** (k=C, D; j=1a, 1b, 2) bezeichnet den Abstand zu z=0 der Unter- beziehungsweise Oberkante des Wickelpakets der Spule kj. Die Größen **r_{E1}**, **r_{E2}**, **r_{H1}** bezeichnen die mittleren Radien der Strukturen E1, E2, H1. Die Größen **z_{GC}** bzw. **z_{GD}** bezeichnen den Abstand zwischen der Ebene z=0 und den Behältern B1 bzw. B2. Die Höhe des Spalts G ist deshalb gegeben durch die Summe der Abstände **z_{GC}**, **z_{GD}** der Ebene z=0 zu den Behältern B1 bzw. B2. Der Einfachheit halber sind in der in Fig. 2 gezeigten Ausführungsform z_{GC} und z_{GD} fix und unabhängig vom Abstand zum Arbeitsvolumen AV. Es ist aber durchaus möglich, dass die Abstände z_{GC} und z_{GD} vom Abstand zum Arbeitsvolumen AV abhängen. Zum Beispiel ist es in Apparaturen für Neutronen- bzw. Röntgenstreuung üblich, dass die Höhe des Spalts G mit dem Abstand zum Arbeitsvolumen AV wächst, um eine gewisse Divergenz des Neutronen- bzw. Röntgenstrahls zu erlauben.

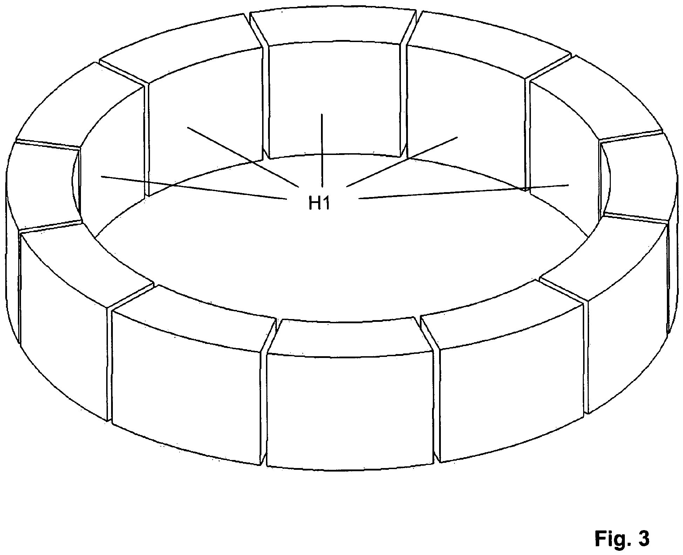

Eine Ausführungsform der erfindungsgemäßen auf Zug belastbaren Struktur H1 ist in **Fig. 3** gezeigt. Die mechanisch auf Zug belastbare Struktur H1 weist mehrere Öffnungen auf, wobei die Grenzflächen der Struktur H1 zu den Öffnungen in oder parallel zu einer Ebene liegen, welche die Symmetrieachse der Struktur H1 (entspricht der z-Achse im eingebauten Zustand) enthält. In dem in Fig. 3 gezeigten Beispiel bilden die Öffnungen Schlitze in radialer Richtung, die aufklaffen oder sich schließen können, sobald die an einer Öffnung angrenzenden Teile der in z-Richtung mechanisch auf Zug belastbaren Struktur H1 Verschiebungen senkrecht zur Richtung der z-Achse erfahren. Dies ist insbesondere dann der Fall, wenn die Magnetanordnung zum Betrieb abgekühlt werden muss und sich die Wärmeausdehnungskoeffizienten der Struktur H1 und der Behälter B1, B2, an denen die Struktur H1 befestigt wird, wesentlich unterscheiden.

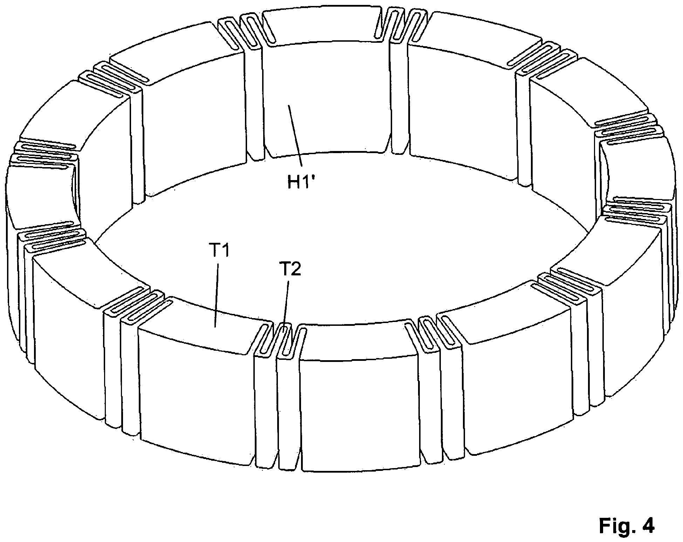

Eine andere Ausführungsform einer erfindungsgemäßen Struktur **H1'** ist in **Fig. 4** dargestellt. Die Struktur H1' ist derart ausgebildet, dass sich massive Teilbereiche **T1** mit tangential deformierbaren Teilbereichen **T2** abwechseln. Die deformierbaren Teilbereiche T2 dieser Struktur können deformiert werden, sobald auf an die Struktur H1 angrenzende Teile eine senkrecht zur Richtung der z-Achse gerichtete Kraft wirkt. Die deformierbaren Teilbereiche T2 weisen in radialer Richtung (senkrecht zur z-Achse) nicht durchgehende Ausnehmungen auf, wodurch sich für die Teilbereiche T2 eine gegenüber den massiven Teilbereichen T1 verringerte Federkonstante ergibt, auch wenn die Struktur vollständig aus einem Material gefertigt ist. In dem gezeigten Beispiel sind die nicht durchgehenden Ausnehmungen im Wechsel auf der Innenseite und der Außenseite der Struktur H1' angeordnet, so dass sich eine einer Ziehharmonika ähnliche Form ergibt (Mäanderform in der Aufsicht).

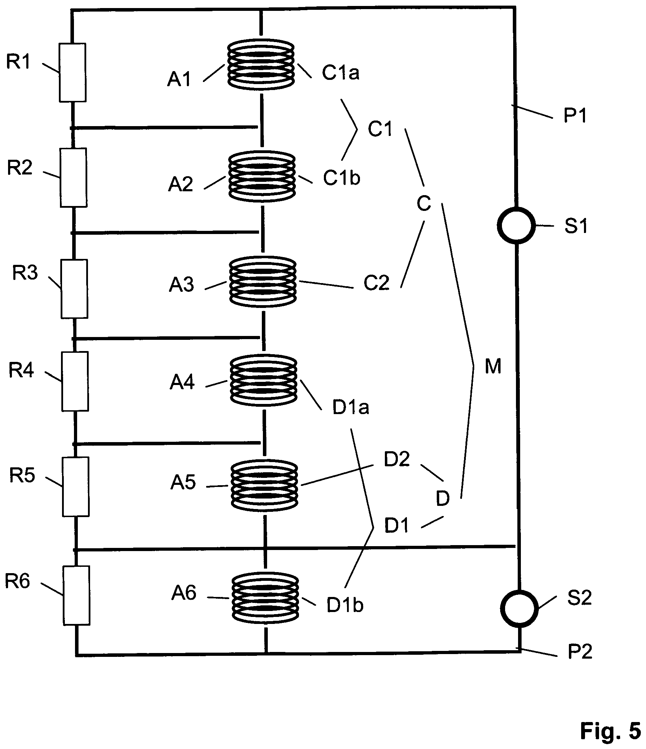

In **Fig. 5** ist ein konventionelles Verdrahtungsschema gezeigt, welches für eine Ausführungsform der erfindungsgemäßen Magnetanordnung mit supraleitenden Spulen geeignet ist. Die Anordnung umfasst zwei supraleitende Strompfade **P1, P2,** welche zusammen in Serie geschaltete Teilspulen der Spulensysteme C, D und je einen parallel dazu geschalteten supraleitenden Schalter umfassen. Der zweite Strompfad P2 umfasst die Teilspule D1b und den Schalter **S2.** Der erste Strompfad P1 umfasst die anderen Teilspulen C1a, C1b, C2, D1a, D2 und den Schalter **S1.** Jede Spule C1a, C1b, D1a, D1b, C2, D2 ist mit einem eigenen Schutzelement **R1, R2, R3, R4, R5, R6** gegen Überhitzung und hohe elektrische Spannungen im Falle eines Zusammenbruchs der Supraleitung (Quench) während des Betriebs geschützt. Insgesamt sind deshalb sechs Schutzabschnitte **A1, A2, A3, A4, A5, A6** vorgesehen.

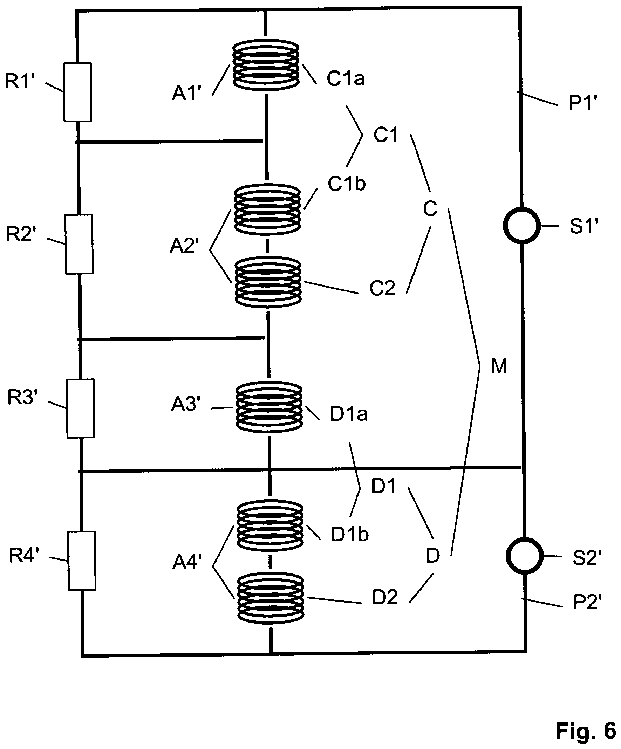

Ein besonders vorteilhaftes Verdrahtungsschema ist in **Fig. 6** gezeigt. Die Anordnung umfasst ebenfalls zwei supraleitende Strompfade **P1'**, **P2'**, welche zusammen in Serie geschaltete Teilspulen der Spulensysteme C, D und je einen parallel dazu geschalteten supraleitenden Schalter umfassen.. Der zweite Strompfad P2' umfasst die Teilspulen D1b und D2 und den Schalter **S2',** der erste Strompfad P1' die anderen Teilspulen C1a, C1b, D1a, C2 und den Schalter **S1'**. Das Magnetspulensystem ist hier in vier Schutzabschnitte **A1'**, **A2'**, **A3'**, **A4'** unterteilt, welche Teile eines ersten Teilspulensystems C1, D1 und/oder eines zweiten Teilspulensystems C2, D2 umfassen. Jeder Schutzabschnitt A1', A2', A3', A4' ist parallel zu je einem Schutzelement **R1**', **R2'**, **R3'**, **R4'** geschaltet. Der erste Schutzabschnitt A1' besteht aus der Teilspule C1a des ersten Teilspulensystems C1. Der zweite Schutzabschnitt A2' besteht aus der Teilspule C1b des ersten Teilspulensystems C1 und dem zweiten Teilspulensystems C2. Der dritte Schutzabschnitt A3' besteht aus der Teilspule D1a des ersten Teilspulensystems D1. Der vierte Schutzabschnitt A4' besteht aus der Teilspule D1b des ersten Teilspulensystems D1 und dem zweiten Teilspulensystems D2. Im Gegensatz zu dem in Fig. 5 gezeigten Verdrahtungsschema umfassen die Schutzabschnitte A1', A2', A3', A4' teilweise sowohl Teilspulen aus einem der ersten Teilspulensysteme C1, D1 als auch aus einem der zweiten Teilspulensysteme C2, D2.

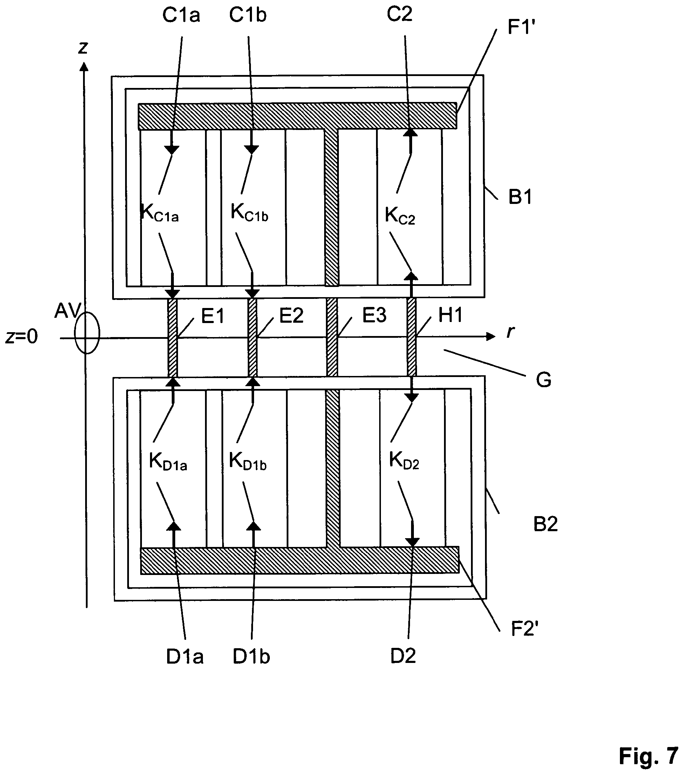

**Fig. 7** zeigt eine weitere erfindungsgemäße Magnetanordnung, bei der zusätzlich zu den auf Druck belastbaren mechanischen Strukturen E1, E2 und zu der auf Zug belastbaren Struktur H1 auf Biegung belastbare Strukturen **F1'**, **F2'** vorgesehen sind, die je innerhalb eines der Behälters B1, B2 das erste Teilspulensystem C1, D1 mit dem zweiten Teilspulensystem C2, D2 mechanisch verbinden, und welche mindestens einen Teil der hinziehenden magnetischen Kräfte K_{C1a}, K_{C1b}, K_{D1a}, K_{D1b} und der forttreibenden magnetischen Kräfte K_{C2}, K_{D2} aufnehmen. Im Spalt ist eine zusätzliche auf Druck belastbare mechanische Struktur **E3** vorhanden.

Im Folgenden wird die Erfindung anhand von verschiedenen Ausführungsformen einer supraleitenden, aktiv abgeschirmten Magnetanordnung erläutert, welche im Arbeitsvolumen AV ein Magnetfeld der Stärke 10 Tesla erzeugt. Der Magnet wird in zwei mit flüssigem Helium gefüllten Behältern B1, B2 bei einer Temperatur von 4.2 Kelvin betrieben. Als Supraleitermaterial wird Niob-Zinn für die Teilspulen C1a und D1a und Niob-Titan für die Teilspulen C1b, C2, D1b, D2 eingesetzt. Der Spalt G ist 10 mm hoch (z_{GC}=z_{GD}=5 mm). Der Einfachheit halber sind alle Teilspulen gleich lang (za_{C2}-zi_{C2}=za_{C1b}-zi_{C1b}=za_{C1a}-zi_{C1a} =za_{D2}-zi_{D2}= za_{D1b}-zi_{D1b}=za_{D1a}-zi_{D1a} =120 mm).

In einer ersten Ausführungsform (im Weiterem "AF1" genannt) sind die zweiten Teilspulensysteme C2, D2 radial nah an den ersten Teilspulensystemen C1, D1 angebracht, wobei ri_{C2}<1.3·ra_{C1b} und ri_{D2}<1.3·ra_{D1b}. Zudem ist die Distanz zwischen dem Wickelpaket der zweiten Teilspulensysteme C2, D2 und dem Spalt G größer als 12 mm (zi_{D2}-z_{GD}=zi_{C2}-z_{GC}=15 mm), während die Wickelpakete der ersten Teilspulensysteme näher am Spalt sind (zi_{C1a}-z_{GC}=zi_{C1b}-z_{GC}=zi_{D1a}-z_{GD}=zi_{D1b}-z_{GD}=10 mm).

In einer zweiten Ausführungsform (im Weiterem "AF2" genannt) sind die zweiten Teilspulensysteme C2, D2 radial weiter entfernt von den ersten Teilspulensystemen C1, D1, wobei ri_{C2}>1.3·ra_{C1b} und ri_{D2}>1.3·ra_{D1b}. Die Distanz zwischen den Wickelpaketen und dem Spalt G ist gleich wie bei der ersten Ausführungsform "AF1" (zi_{D2}-z_{GD}=zi_{C2}-z_{GC}=15 mm, zi_{C1a}-z_{GC}=zi_{C1b}-z_{GC}=zi_{D1a}-z_{GD}=zi_{D1b}-z_{GD}=10 mm).

In einer dritten Ausführungsform (im Weiterem "AF3" genannt) sind die zweiten Teilspulensysteme C2, D2 radial weit entfernt von den ersten Teilspulensystemen C1, D1 wie bei der zweiten Ausführungsform AF2, wobei ri_{C2}>1.3·ra_{C1b} und ri_{D2}>1.3·ra_{D1b}. Die Distanz zwischen dem Wickelpaket der zweiten Teilspulensysteme C2, D2 und dem Spalt G ist aber kleiner als 12 mm und gleich wie die Distanz zwischen dem Wickelpaket der ersten Teilspulensysteme C1, D1 und dem Spalt G (zi_{D2}-z_{GD}=zi_{C2}-z_{GC}=zi_{C1a}-z_{GC}=zi_{C1b}-z_{GC}=zi_{D1a}-z_{GD}=zi_{D1b}-z_{GD}=10 mm).

Tabelle 1 zeigt einen Vergleich der wichtigsten Merkmale der Ausführungsformen AF1, AF2 und AF3. Damit die drei Ausführungsformen AF1, AF2 und AF3 miteinander verglichen werden können, wurden sie so ausgelegt, dass das Magnetfeld im Arbeitsvolumen und die 5 Gauß Linie R_{5G}, definiert als die Distanz von der Magnetachse ab welcher die Streufeldstärke von 5 Gauß unterschritten wird, in allen Fällen gleich ist. (ohne Abschirmung R_{5G} = ca. 2.2 m)

**Tabelle 1**

| | AF1 | AF2 | AF3 |
|---|---|---|---|
| B [T] | 10 | 10 | 10 |
| J_{C1a}=J_{D1a} [A/mm²] | 137 | 128 | 130 |
| J_{C1b}=J_{D1b} [A/mm²] | 264 | 247 | 249 |
| J_{C2}=J_{D2} [A/mm²] | -264 | -247 | -249 |
| R_{5G} [m] | 0.72 | 0.71 | 0.72 |
| ri_{C1a} = ri_{D1a} [mm] | 35 | 35 | 35 |
| ra_{C1a} = ra_{D1a} [mm] | 78.5 | 78.5 | 78.5 |
| ri_{C1b} = ri_{D1b} [mm] | 83 | 83 | 83 |
| ra_{C1b} = ra_{D1b} [mm] | 122.1 | 122.1 | 122.1 |
| ri_{C2} = ri_{D2} [mm] | 152 | 167 | 167 |
| ra_{C2} = ra_{D2} [mm] | 170.8 | 182.7 | 182.7 |
| Zi_{C1a} = zi_{D1a} [mm] | 15 | 15 | 15 |
| za_{C1a} = za_{D1a} [mm] | 135 | 135 | 135 |
| zi_{C1b} = zi_{D1b} [mm] | 15 | 15 | 15 |
| za_{C1b} = za_{D1b} [mm] | 135 | 135 | 135 |
| zi_{C2} = zi_{D2} [mm] | 20 | 20 | 15 |
| za_{C2} = za_{D2} [mm] | 140 | 140 | 135 |

In Tabelle 1 bezeichnet Jₖⱼ (k=C, D; j=1a, 1b, 2) jeweils die Stromdichte in der Spule kj.

Für die drei Ausführungsformen AF1, AF2 und AF3 zeigt Tabelle 2 die berechneten axialen magnetischen Kräfte aller Teilspulen auf das Teilspulensystem D2 in [kN] im Betriebszustand

**Tabelle 2**

| | AF1 | AF2 | AF3 |
|---|---|---|---|
| K_{C1a↔D2} | -62 | -42 | -44 |
| K_{C1b↔D2} | -343 | -238 | -252 |
| K_{C2↔D2} | 319 | 222 | 257 |
| K_{D1a↔D2} | -7 | -4 | 0 |
| K_{D1b↔D2} | -51 | -30 | 0 |
| **K_{D2}** | **-144** | **-92** | **-39** |

In Tabelle 2 bezeichnet K_{kj↔D2} (k=C, D; j=1a, 1b, 2) den Beitrag der axialen Kraft auf D2, der von der Spule kj herrührt.

Der Vergleich der Variante AF2 mit der Variante AF1 zeigt, dass die forttreibenden magnetischen Kräfte erheblich reduziert werden können, wenn man den Abstand zwischen den ersten und zweiten Teilspulensystemen vergrößert. Im Beispiel werden die magnetischen Kräfte auf D2 etwa 40% kleiner bei einer Erhöhung von etwa 50% in ri_{C2} - ra_{C1b} und ri_{D2} - ra_{D1b}.

Der Vergleich der Variante AF3 mit der Variante AF2 zeigt, dass die magnetischen Kräfte erheblich reduziert werden können, wenn die zweiten Teilspulensysteme C2, D2 axial näher beim Spalt G positioniert werden. Bei einer axialen Verschiebung von C2 bzw. D2 von 5 mm in Richtung des Spaltes G werden im Beispiel die vom Spalt G forttreibenden Beiträge zur Gesamtkraft K_{D2} (K_{C1a↔D2} + K_{C1b↔D2} + K_{D1a↔D2} + K_{D1b↔D2}) leicht kleiner (-6%) während der zum Spalt G hinziehende Beitrag zur Gesamtkraft K_{D2} (K_{C2↔D2}) stark zunimmt (+16%). Insgesamt wird die resultierende forttreibende Kraft K_{D2} um mehr als einen Faktor 2 reduziert.

Nach dem Stand der Technik ist im Spalt lediglich eine auf Druck belastbare Struktur E vorgesehen, welche die resultierenden magnetischen Kräfte (K_{C}=K_{C1a}+ K_{C1b}+ K_{C2}, K_{D}=K_{D1a}+ K_{D1b}+ K_{D2}) aufnimmt. Für die Ausführungsform AF3 könnten 4 Stangen mit einem Durchmesser von 32 mm und einer maximal zulässigen Spannung von 200 N/mm² die resultierenden magnetischen Kräfte im Betriebszustand (K_{C}=-K_{D}= 162kN + 527 kN - 39 kN = 650 kN) aufnehmen. In jedem Behälter B1 und B2 würden die magnetischen Kräfte K_{C1a}, K_{C1b}, K_{C2} beziehungsweise K_{D1a}, K_{D1b}, K_{D2} zwischen den ersten und zweiten Teilspulensystemen C1 beziehungsweise C2 und D1 beziehungsweise D2 von je einer starren Struktur F1 beziehungsweise F2 aufgenommen. Diese Strukturen F1, F2 wären aber auf Biegung belastet und müssten entsprechend dimensioniert werden. Für die Ausführungsform AF3 könnten sechs 30 mm breite Balken diese Kräfte aufnehmen. Damit die maximal zulässige Biegespannung von 200 N/mm² im Betriebszustand nicht überschritten wird, müssten diese Balken aber mindestens 80 mm dick sein, wenn sie mittels eines Ringes zwischen C1b und C2 beziehungsweise D1b und D2 abgestützt würden. An der Stützstelle jedes Balkens würde nämlich ein Drehmoment von rund 6000 N*m wirken. Das wirkliche Problem ist nun, dass keine mechanische Struktur mit dem zur Verfügung stehenden Platz in der Lage wäre, ein dermaßen großes Drehmoment in den Ring zu übertragen. Dieses Beispiel zeigt also deutlich, dass ein Spulensystem der Variante AF3 mit herkömmlichen Methoden gar nicht gebaut werden könnte.

Erfindungsgemäß sind im Spalt G zwei auf Druck belastbare mechanische Strukturen E1 bzw. E2 vorhanden, welche die hinziehenden magnetischen Kräfte K_{C1a} und K_{D1a} bzw. K_{C1b} und K_{D1b} aufnehmen, und eine auf Zug belastbare Struktur H1, welche die forttreibenden magnetischen Kräfte K_{C2}, K_{D2} aufnimmt. Diese Strukturen sind ausschließlich auf Druck bzw. Zug und nicht auf Biegung belastet, abgesehen von den sehr kleinen Biegebelastungen, die sich aufgrund eventueller unterschiedlicher thermischer Ausdehnungskoeffizienten der Behälter B1, B2 und der Struktur H1 ergeben, wenn die Magnetanordnung auf eine tiefe Betriebstemperatur (typischerweise 4.2 K im Falle einer supraleitenden Magnetanordnung) abgekühlt wurde..

In einer erfindungsgemäßen Ausführungsform für Neutronenstreuung bestehen die auf Druck und Zug belastbaren mechanischen Strukturen E1, E2, H1 beispielsweise aus dünnen Aluminium-Ringen. Aluminium wird für die Strukturen im Spalt gewählt, da die Wechselwirkung zwischen den Neutronen und Aluminium gering ist. Somit können die Neutronen 360 Grad um das Arbeitsvolumen fast unbehindert gestreut werden. Für die Ausführungsform AF3 können drei dünne Ringe mit je einer maximal zulässigen Spannung von 200 N/mm² die magnetischen Kräfte im Betriebszustand aufnehmen. Diese Ringe sollen eine Dicke von mindestens 2.3 mm, 4.1 mm und 0.2 mm aufweisen und bei
r_{E1}=(ra_{C1a}+ri_{C1a})/2 =56.75 mm, r_{E2}=(ra_{C1b}+ri_{C1b})/2 =102.55 mm, r_{H1}=(ra_{C2}+riC₂)/2 =174.85 mm positioniert werden.

Die auf Druck belastbaren mechanischen Strukturen E1, E2 werden ohne Schrauben im Spalt G eingelegt. Die auf Zug belastbare mechanische Struktur H1 wird entweder durch Stoffschluss oder formschlüssig mit den Behältern B1, B2 verbunden. Zum Beispiel kann man insgesamt sechzehn M8 Schrauben (5 kN pro Schraube) verwenden, wobei aber die Dicke und Geometrie von H1 entsprechend angepasst werden muss.

Der Vorteil der erfindungsgemäßen Anordnung besteht darin, dass innerhalb der Behälter keine starre Struktur zur Verbindung der Teilspulensysteme miteinander benötigt wird, um die magnetischen Kräfte in den Spulensystemen aufzunehmen. Der mechanische Aufbau ist deshalb billiger, einfacher, Platz und Gewicht sparender.

Wenn man die Stärke der mechanischen Struktur im Spalt reduzieren will, kann man zusätzliche auf Biegung belastbare Strukturen radial zwischen den ersten Teilspulensystemen und den zweiten Teilspulensystemen verwenden, welche einen Teil der hinziehenden magnetischen Kräfte und der forttreibenden magnetischen Kräfte aufnehmen (siehe Fig. 7). Somit kann man einerseits die Materialmenge im Spalt reduzieren, wobei andererseits die auf Biegung belastbaren Strukturen dünner als 80 mm (Stand der Technik) dimensioniert sein können, so dass mehr Platz für Kühlflüssigkeit innerhalb der Behälter zur Verfügung steht, beziehungsweise die Behälter kleiner und somit die Magnetanordnung kompakter dimensioniert werden können.

In einer erfindungsgemäßen Ausführungsform wird Stahl für die Behälter wegen der guten mechanischen Eigenschaften gewählt. Somit können die Behälter B1 und B2 am Spalt dünnwandig ausgestatten werden. Da sich Aluminium und Stahl schlecht mittels stoffschlüssiger Verfahren verbinden lassen, ist es vorteilhaft, die mechanisch auf Zug belastbare Struktur H1 mit den Behältern B1, B2 zusammenzuschrauben. Zudem erlaubt die Verbindung mit Schrauben auch eine einfache Montage und eine zerstörungsfreie Demontage der Struktur H1.

Wenn die Magnetanordnung auf eine tiefe Betriebstemperatur gekühlt wird (typischerweise 4.2 K im Falle einer supraleitenden Magnetanordnung) werden sich die Aluminium-Ringe viel stärker als die Stahl-Behälter zusammenziehen, da der Absolutbetrag der Differenz der relativen thermischen Längenänderungen von Stahl und Aluminium nach Erreichen einer Betriebstemperatur von 4.2 K größer als 0.1% ist. Für die Ausführungsform AF3 würde sich der Aluminium Ring H1 beim Abkühlen um 0.7 mm radial zusammenziehen, während sich die Behälter B1 und B2 radial um nur 0.5 mm nach innen verschieben würden. Ohne zusätzliche Maßnahmen würden die Schrauben, die den Aluminium Ring H1 mit dem Behälter B1 oder B2 verbinden, stark belastet werden.

Um solche Kräfte auf die Schrauben zu vermeiden, kann man erfindungsgemäß den Aluminium Ring H1 mittels Schlitzen in mehrere Elemente zerlegen (siehe Fig. 3). Wenn man ein Element mit jeweils einer Schraube befestigt, erfahren die Schrauben keine Scherkräfte beim Abkühlen. Als Alternative kann man den Aluminium Ring dermaßen ausbilden, dass Teilbereiche dieser Struktur tangential definiert deformiert werden können, sobald an die Struktur angrenzende Teile eine senkrecht zur Richtung der z-Achse gerichtete Deformation erfahren (siehe Fig. 4).

Bei Neutronenstreuungsexperimenten mit polarisierten Neutronen sind Feldnulldurchgänge in der Nähe der Ebene z=0 unerwünscht, da polarisierte Neutronen dort ihre Spinausrichtung verlieren würden. In der Ausführungsform AF3 gibt es einen Nullfelddurchgang bei (r,z)=(106 mm, 0 mm), wenn alle Spulen der Magnetanordnung den gleichen Strom tragen. Dieser Nullfelddurchgang kann sowohl axial als auch radial aus dem Spalt verschoben werden, indem man die Spulen auf zwei Strompfade verteilt, welche im Betriebszustand verschiedene Stromstärken tragen können.

Erfindungsgemäß soll verhindert werden, dass die magnetischen Kräfte und Streufelder zu groß werden, wenn unterschiedliche Ströme in verschiedenen Strompfaden fließen.

In einem konventionellen Verdrahtungsschema der Ausführungsform AF3 (siehe Fig. 5) umfasst der zweite Strompfad P2 die Teilspule D1b. Wenn der zweite Strompfad P2 mit 2/3 des Stroms in P1 geladen wird, verschiebt sich der Feldnulldurchgang nach (r,z)=(102 mm, -7 mm) außerhalb des Spalts. Somit können 8.7 Tesla im Arbeitsvolumen AV erzeugt werden, die 5G-Linie liegt aber doppelt so weit vom Arbeitsvolumen AV entfernt (R_{5G}=1.33 m) als im symmetrischen Betriebszustand. Die Kraft K_{C2} ist jetzt zum Spalt hinziehend (K_{C2}=-45 kN), da die forttreibende Komponente K_{D1b↔C2} kleiner geworden ist. Die Kraft K_{D2} ist immer noch vom Spalt forttreibend (K_{D2}=-39 kN). Die Struktur H1 wäre in diesem Fall auf Druck statt auf Zug belastet. Um die erfindungsgemäß Magnetanordnung auch mit diesen Parametern zu betreiben, müsste die auf Zug belastbare Struktur H1, H1' zusätzlich auch auf Druck belastbar sein.

In einem erfindungsgemäßen Verdrahtungsschema der Ausführungsform AF3 (siehe Fig. 6) umfasst der zweite Strompfad P2' die Spulen D1b und D2. Wenn der zweite Strompfad P2' mit 2/3 des Stroms in P1' geladen wird, verschiebt sich der Feldnulldurchgang nach (r,z)=(105 mm, -6 mm) außerhalb des Spalts. Somit können 9.1 Tesla im Arbeitsvolumen AV erzeugt werden und die 5G-Linie liegt nur 20% weiter vom Arbeitsvolumen AV entfernt als im symmetrischen Betriebszustand (R_{5G}=0.88 m). Die Kräfte K_{C2} und K_{D2} sind immer noch vom Spalt forttreibend (K_{C2}=41 kN, K_{D2}=-26 kN). K_{C2} ist nur leicht größer als im symmetrischen Betriebszustand, da die Komponenten der Kräfte K_{D2↔C2} und K_{D1b↔C2} etwa gleich im Betrag aber in entgegensetzter Richtung sind (siehe Tabelle 2). Somit ist die Summe der Kräfte zwischen D2 und C2 bei jedem Strom im Strompfad P2' sehr klein.

Erfindungsgemäß soll auch verhindert werden, dass die magnetischen Kräfte zu stark anwachsen im Fall eines Quenchs.

Konventionell würde man jede Spule C1a, C1b, D1a, D1b, C2, D2 mit einem eigenen Schutzelement schützen (siehe Fig. 5), zum Beispiel mit Schutzwiderständen R1, R2, R3, R4, R5, R6.

Erfindungsgemäß werden Teile eines zweiten Teilspulensystems C2, D2 und Teilspulen C1a, C1b, D1a, D1b eines ersten Teilspulensystems C1, D1 als Schutzabschnitt A1', A2', A3', A4' zusammen in Serie und parallel zu einem gemeinsamen Schutzelement geschaltet (siehe Fig. 6), zum Beispiel zu Schutzwiderständen R1', R2', R3', R4'. In der Praxis würde man eine feinere Spulenunterteilung bevorzugen, aber die Aufteilung auf insgesamt sechs bzw. vier Schutzabschnitte ist eine einfache Anordnung, anhand welcher sich die Problematik der Kräfte im Quenchfall und die erfindungsgemäße Lösung des Problems bereits gut diskutieren lassen.

Tabelle 3 zeigt für die Ausführungsform AF3 die Stromdichten in den Teilspulen, die magnetischen Kräfte auf das Teilspulensystem C2 und die Distanz der 5G-Linie vom Arbeitsvolumen AV, zwei Sekunden nach einem Quenchbeginn im Teilspulensystem D2. In den Simulationen sind alle Schutzwiderstände R1, R2, R3, R4, R5, R6, R1', R2', R3', R4' auf 0.5 Ohm gesetzt und es wird angenommen, dass der Widerstand des Spulensystems D2 innerhalb von 3 Sekunden von 0 Ohm bis 13.8 Ohm linear ansteigt. Somit ist die Kraft K_{C2} ca. 2 Sekunden nach dem Quenchbeginn maximal.

**Tabelle 3**

| AF3 | Betriebszustand | 2 s nach Quench konventionelle Verdrahtung nach Fig. 5 | 2 s nach Quench erfindungsgemäße Verdrahtung nach Fig. 6 |
|---|---|---|---|
| J_{C1a} [A/mm²] | 130 | 118 | 150 |
| J_{C1b} [A/mm²] | 249 | 240 | 261 |
| J_{C2} [A/mm²] | -249 | -272 | -261 |
| J_{D1a} [A/mm²] | 130 | 119 | 228 |
| J_{D1b} [A/mm²] | 249 | 188 | 37 |
| J_{D2} [A/mm²] | -249 | -16 | -37 |
| K_{D1a↔C2} [kN] | 44 | 45 | 81 |
| K_{D1b↔C2} [kN] | 252 | 208 | 39 |
| K_{D2↔C2} [kN] | -257 | -17 | -40 |
| K_{C1a↔C2} [kN] | 0 | 0 | 0 |
| K_{C1b↔C2} [kN] | 0 | 0 | 0 |
| **K_{C2} [kN]** | **39** | **236** | **80** |
| R_{5G} [m] | 0.72 | 1.8 | 1.4 |
| Anzahl M8 Schrauben für H1, H1' | 16 | 96 | 32 |

Ohne weitere Maßnahmen birgt das konventionelle Schutzkonzept die Gefahr einer massiven Erhöhung der magnetischen Kräfte, wenn im Teilspulensystem D2 ein Quench ausbricht, welcher sich thermisch nicht sofort auf das Teilspulensystem C2 überträgt. In diesem Fall fehlt kurzfristig die anziehende Komponente K_{D2↔C2} der Kraft auf C2. Somit werden die forttreibenden Kräfte K_{C2} zwei Sekunden nach dem Quenchbeginn etwa 6-mal Größer als im Betriebszustand. Um solche Kräfte aufnehmen zu können, braucht man mindestens 96 M8 Schrauben (statt 16 Schrauben) für die Befestigung der auf Zug belastbaren Struktur H1, H1' an den Behältern B1 und B2.

Diese Gefahr ist mit dem in Fig. 6 vorgestellten Schutzkonzept dadurch gebannt, dass sich die Teilspule D1b zusammen mit dem Teilspulensystem D2 entlädt. Dies bewirkt, dass die anziehende Komponente K_{D2↔C2} der Kraft auf C2 und die forttreibende Komponente K_{D1b↔C2} der Kraft auf C2 gleichzeitig verschwinden. Die vom Spalt G forttreibenden Kräfte auf das Teilspulensystem C2 werden aber gegenüber dem Betriebszustand immer noch um einen Faktor 2 größer, was auf das Überladen der Teilspule D1a zurückzuführen ist. Um solche Kräfte aufnehmen zu können, braucht man mindestens 32 M8 Schrauben für die Befestigung der auf Zug belastbaren Struktur H1, H1' an den Behältern B1 und B2.

Die Streufelder während des Quenchs des Teilspulensystems D2 können mit dem erfindungsgemäßen Schutzkonzept gemäß Fig. 6 auch besser unterdrückt werden (R_{5G}=1.4 m statt R_{5G}=1.8 m zwei Sekunden nach dem Quenchbeginn). Mit einer Optimierung des Schutzkonzepts könnte man diesen Wert noch weiter reduzieren.

### Bezugszeichenliste

- A1 - A6, A1' - A4': Schutzabschnitte
- AV: Arbeitsvolumen
- B1, B2: Behälter
- C, D: Spulensysteme
- C1, D1: erste Teilspulensysteme
- C1a, C1b, D1a, D1b: Teilspulen der ersten Teilspulensysteme
- C2, D2: zweite Teilspulensysteme
- E, E1, E2, E3: auf Druck belastbare mechanische Strukturen
- F1, F2, F1', F2': starre Strukturen innerhalb der Behälter
- G: Spalt
- H1, H1': auf Zug belastbare Strukturen
- K_{C}, K_{D}, K_{C1}, K_{D1}, K_{C1a},: zum Spalt hinziehende magnetische Kräfte
- K_{C1b}, K_{D1a}, K_{D1b} K_{C2}, K_{D2}: vom Spalt forttreibende magnetische Kräfte
- M: Magnetspulensystem
- P1, P2, P1', P2': supraleitende Strompfade
- R1-R6, R1'-R4': Schutzelemente
- raₖⱼ: Außenradien der Wickelpakete der Teilspule kj (k=C, D; j=1a, 1b, 2)
- r_{E1}, r_{E2}, r_{H1}: mittlere Radien der Strukturen E1, E2, H1
- riₖⱼ: Innenradien der Wickelpakete der Teilspule kj (k=C, D; j=1a, 1b, 2)
- Rp_{0.2}: Mechanische Spannung, bei der eine bleibende Dehnung von 0.2% resultiert.
- S1, S2, S1', S2': supraleitende Schalter
- T1: massive Teilbereiche der auf Zug belastbaren Struktur
- T2: deformierbare Teilbereiche der auf Zug belastbaren Struktur
- zaₖⱼ: Abstand der Oberkante des Wickelpakets der Spule kj zu z=0 (k=C, D; j=1a, 1b, 2)
- z_{GC}, z_{GD}: Abstand der Ebene z=0 zu den Behältern B1 bzw. B2
- ziₖⱼ: Abstand der Unterkante des Wickelpakets der Spule kj zu z=0 (k=C, D; j=1a, 1b, 2)

### Referenzliste

1 US 6,717,408 B2
2 G. Claudet et al., Cryogenics, Vol. 21, No. 12, Dez. 1981, Seiten 711-714
3 JP2001230114
4 C. Minas und E.T. Laskaris, IEEE Transactions on Applied Superconductivity, Vol. 5 , No. 2, Juni 1995, Seiten 173-176
5 E.T. Laskaris et al., IEEE Transactions on Applied Superconductivity, Vol. 5 , No. 2, Juni 1995, Seiten 163-168
6 US 5,291,169
7 EP 0 971 240 A2
8 US 6,150,912
9 US 5,448,214
10 JP 2006141613

## Patentansprüche

1. Magnetanordnung mit einem Magnetspulensystem (M) zur Erzeugung eines Magnetfeldes in Richtung einer z-Achse in einem auf der z-Achse um z=0 angeordneten Arbeitsvolumen (AV) mit zwei um die z-Achse positionierten Behältern (B1, B2) und mit zwei Spulensystemen (C, D), die in je einem der Behälter (B1, B2) angeordnet sind, wobei die Behälter (B1, B2) je eines der beiden Spulensysteme vollständig umschließen und mechanisch durch einen Spalt (G) axial bezüglich der z-Achse voneinander getrennt sind,
wobei die Spulensysteme (C, D) jeweils ein erstes Teilspulensystem (C1, D1) umfassen und mindestens eines der Spulensysteme (C, D) ein zweites Teilspulensystem (C2, D2) umfasst, wobei jedes Teilspulensystem (C1, C2, D1, D2) mindestens einen Spulenkörper und mindestens ein felderzeugendes Wickelpaket aufweist, wobei die ersten Teilspulensysteme (C1, D1) im Betriebszustand je einer in axialer Richtung zum Spalt (G) hinziehenden resultierenden magnetischen Kraft (K_{C1}, K_{D1}) ausgesetzt sind, und wobei die zweiten Teilspulensysteme (C2, D2) im Betriebszustand je einer in axialer Richtung vom Spalt (G) forttreibenden resultierenden magnetischen Kraft (K_{C2}, K_{D2}) ausgesetzt sind,
wobei diese magnetischen Kräfte mindestens teilweise mechanisch auf die Behälter (B1, B2) übertragen werden, und
mit mindestens einer auf Druck belastbaren mechanischen Struktur (E, E1, E2), welche im Spalt (G) angeordnet ist und im Betriebszustand mindestens einen Teil der hinziehenden magnetischen Kräfte (K_{C1}, K_{D1}) aufnimmt,
**dadurch gekennzeichnet,**
**dass** im selben Spalt (G) radial, d.h. in Richtung senkrecht zur z-Achse, innerhalb der Abmessungen beider Behälter (B1, B2) zusätzlich zu der auf Druck belastbaren mechanischen Struktur (E, E1, E2) eine weitere mechanische Struktur (H1) vorgesehen ist, die in z-Richtung mechanisch auf Zug belastbar ist und im Betriebszustand mindestens einen Teil der in axialer Richtung forttreibenden magnetischen Kräfte (K_{C2}, K_{D2}) aufnimmt, wobei die weitere mechanisehe Struktur (H1) mit beiden Behältern (B1, B2) verbunden ist und diese zusammenhält.

2. Magnetanordnung nach Anspruch 1, **dadurch gekennzeichnet, dass** der größte Winkelbereich um die z-Achse ohne Kontaktstellen zwischen der mechanisch auf Zug belastbaren Struktur (H1) und den beiden Behältern (B1, B2) kleiner oder gleich 180° ist.

3. Magnetanordnung nach einem der Ansprüche 1 oder 2, **dadurch gekennzeichnet, dass** die in z-Richtung mechanisch auf Zug belastbare Struktur (H1) mit den Behältern (B1, B2) durch Stoffschluss verbunden ist.

4. Magnetanordnung nach einem der Ansprüche 1 oder 2, **dadurch gekennzeichnet, dass** die in z-Richtung mechanisch auf Zug belastbare Struktur (H1) mit den Behältern (B1, B2) formschlüssig verbunden ist.

5. Magnetanordnung nach einem der vorhergehenden Ansprüche, **dadurch gekennzeichnet, dass** die Spulenkörper der ersten Teilspulensysteme (C1, D1) und der zweiten Teilspulensysteme (C2, D2), die in z-Richtung mechanisch auf Zug belastbare Struktur (H1) und die Behälter (B1, B2) aus demselben Material gefertigt sind.

6. Magnetanordnung nach einem der Ansprüche 1 bis 4, **dadurch gekennzeichnet, dass** die Spulenkörper der ersten Teilspulensysteme (C1, D1) und der zweiten Teilspulensysteme (C2, D2), die in z-Richtung mechanisch auf Zug belastbare Struktur (H1) und die Behälter (B1, B2) aus mindestens zwei verschiedenen Materialien gefertigt sind.

7. Magnetanordnung nach Anspruch 6, **dadurch gekennzeichnet, dass** der Absolutbetrag der Differenz der relativen thermischen Längenänderungen mindestens zweier der verschiedenen Materialien nach Erreichen einer Betriebstemperatur, welche sich von der Temperatur bei der mechanischen Montage der Magnetanordnung unterscheidet, kleiner als 0.1% ist.

8. Magnetanordnung nach einem der Ansprüche 6 oder 7, **dadurch gekennzeichnet, dass** die in z-Richtung mechanisch auf Zug belastbare Struktur (H1) mehrere Segmente umfasst, die um die z- Achse angeordnet sind, wobei die Segmente azimutal voneinander beabstandet sind.

9. Magnetanordnung nach einem der Ansprüche 6 bis 8, **dadurch gekennzeichnet, dass** die mechanisch auf Zug belastbare Struktur (H1') mindestens einen ersten, nicht deformierbaren Teilbereich (T1) und mindestens einen weiteren Teilbereich (T2), der in einer Richtung senkrecht zur z-Achse deformierbar ist, umfasst.

10. Magnetanordnung nach einem der vorhergehenden Ansprüche, **dadurch gekennzeichnet, dass** in mindestens einem der Behälter (B1, B2) mindestens eine zusätzliche auf Biegung belastbare Struktur (F1', F2') mit dem ersten Teilspulensystem (C1, D1) und dem zweiten Teilspulensystem (C2, D2) mechanisch verbunden ist und mindestens einen Teil der hinziehenden magnetischen Kräfte (K_{C1}, K_{D1}) und der forttreibenden magnetischen Kräfte (K_{C2}, K_{D2}) aufnimmt.

11. Magnetanordnung nach einem der vorhergehenden Ansprüche, **dadurch gekennzeichnet, dass** mindestens eines der zweiten Teilspulensysteme (C2, D2), vorzugsweise beide zweiten Teilspulensysteme (C2, D2), radial außerhalb des entsprechenden ersten Teilspulensystems (C1, D1) angebracht ist und im Betriebszustand das magnetische Dipolmoment der beiden ersten Teilspulensysteme (C1, D1) zu mindestens 50% kompensiert.

12. Magnetanordnung nach einem der vorhergehenden Ansprüche, **dadurch gekennzeichnet, dass** die durch den Spalt (G) getrennten Spulensysteme (C, D) mechanisch und geometrisch gleich gebaut und symmetrisch zur Ebene, welche senkrecht zur z-Achse liegt und diese auf der Höhe z=0 schneidet, in den Behältern (B1, B2) positioniert sind.

13. Magnetanordnung nach einem der vorhergehenden Ansprüche, **dadurch gekennzeichnet, dass** die durch den Spalt (G) getrennten Spulensysteme (C, D) mechanisch und geometrisch unterschiedlich aufgebaut und/oder asymmetrisch zur Ebene, welche senkrecht zur z-Achse liegt und diese auf der Höhe z=0 schneidet, in den Behältern (B1, B2) positioniert sind.

14. Magnetanordnung nach einem der vorhergehenden Ansprüche, **dadurch gekennzeichnet, dass** die Teilspulensysteme (C1, C2, D1, D2) zylindrisch sind und der Innenradius (ri_{D2}, ri_{C2}) mindestens eines der zweiten Teilspulensysteme (C2, D2) größer ist als 1.3-mal der Außenradius (ra_{D1}, ra_{C1}) eines der ersten Teilspulensysteme (C1, D1).

15. Magnetanordnung nach einem der vorhergehenden Ansprüche **dadurch gekennzeichnet, dass** die Distanz (zi_{C2}-z_{GC}, zi_{D2}-z_{GD}) zwischen dem Wickelpaket eines der zweiten Teilspulensysteme (C2, D2) und dem Spalt (G) kleiner als 12 mm ist.

16. Magnetanordnung nach einem der vorhergehenden Ansprüche, **dadurch gekennzeichnet, dass** eine oder mehrere Teilspulensysteme zumindest teilweise supraleitend sind.

17. Magnetanordnung nach Anspruch 16, **dadurch gekennzeichnet, dass** ein zweites Teilspulensystem (C2, D2) oder Teile davon und ein erstes Teilspulensystem (C1, D1) oder Teile (C1a, C1b, D1a, D1b) davon als Schutzabschnitt (A1', A2', A3', A4') zusammen in Serie geschaltet sind, wobei der Schutzabschnitt (A1', A2', A3', A4') parallel zu einem gemeinsamen Schutzelement (R1', R2', R3', R4') geschaltet ist.

18. Magnetanordnung nach Anspruch 17, **dadurch gekennzeichnet, dass** im Betriebszustand in mindestens einem der Schutzabschnitte (A1', A2', A3', A4') die magnetischen Dipolmomente der Teile des zweiten Teilspulensystems (C2, D2) die magnetischen Dipolmomente der Teile (C1a, C1b, D1a, D1b) des ersten Teilspulensystems (C1, D1) zu mindestens 50% kompensieren.

19. Magnetanordnung nach einem der Ansprüche 16 bis 18, **dadurch gekennzeichnet, dass** ein zweites Teilspulensystem (C2, D2) oder Teile davon und ein erstes Teilspulensystems (C1, D1) oder Teile (C1a, C1b, D1a, D1b) davon innerhalb eines supraleitenden Strompfads (P1, P1', P2') zusammen in Serie und parallel zu einem supraleitenden Schalter (S1, S1', S2') geschaltet sind.

20. Magnetanordnung nach Anspruch 19, **dadurch gekennzeichnet, dass** im Betriebszustand in mindestens einem der supraleitenden Strompfade (P1, P1', P2') die magnetischen Dipolmomente der Teile des zweiten Teilspulensystems (C2, D2) die magnetischen Dipolmomente der Teile (C1a, C1b, D1a, D1b) des ersten Teilspulensystems (C1, D1) zu mindestens 50% kompensieren.

21. Magnetanordnung nach einem der vorhergehenden Ansprüche, **dadurch gekennzeichnet, dass** die zwei Behälter (B1, B2) mit Kühlflüssigkeiten gefüllt sind.

22. Magnetanordnung nach einem der vorhergehenden Ansprüche, **dadurch gekennzeichnet, dass** eine Vorrichtung zur aktiven Kühlung der Behälter (B1, B2) vorgesehen ist.

23. Apparatur für Neutronenstreuung, Apparatur für Röntgenstreuung oder MRI-Apparatur mit einer Magnetanordnung nach einem der vorhergehenden Ansprüche.

## Claims

1. Magnet arrangement with a magnet coil system (M) for producing a magnetic field in the direction of a z axis in a working volume (AV) arranged on the z axis around z=0 with two containers (B1, B2) that are positioned around the z axis and two coil systems (C, D) that are each arranged in a container (B1, B2), wherein the containers (B1, B2) each completely surround one of the two coil systems and are mechanically axially separated from each other with respect to the z axis by a split (G),
wherein the coil systems (C, D) each include a first coil section system (C1, D1) and at least one of the coil systems (C, D) includes a second coil section system (C2, D2), each coil section system (C1, C2, D1, D2) comprising at least one coil body and at least one field-generating winding package, wherein in the operating state the first coil section systems (C1, D1) are exposed to attractive magnetic forces (K_{C1}, K_{D1}) in the axial direction toward the split (G), and wherein in the operating state the second coil sections (C2, D2) are exposed to repulsive magnetic forces (K_{C2}, K_{D2}) in the axial direction away from the split (G),
wherein these magnetic forces are at least partly mechanically transmitted to the containers (B1, B2), and
with at least one mechanical structure (E, E1, E2) that withstands compressive loads that is arranged in the split (G) and that supports at least a part of the attractive magnetic forces (K_{C1}, K_{D1}) in the operating state,
**characterized in that**
in addition to the structure (E, E1, E2) that withstands compressive loads, a further mechanical structure (H1) that mechanically withstands tensile loads in the z direction and that supports at least a part of the repulsive magnetic forces (K_{C2}, K_{D2}) in the axial direction in the operating state is arranged radially in the same split (G), i.e. in a direction perpendicular to the z axis, within the dimensions of both containers (B1, B2), wherein the further mechanical structure (H1) is connected to both containers (B1 , B2) and holds them together.

2. Magnet arrangement according to claim 1, **characterized in that** the largest angular range about the z axis without contact points between the structure (H1) that mechanically withstands tensile loads and the two containers (B1, B2) is less than or equal to 180°.

3. Magnet arrangement according to either one of the claims 1 or 2, **characterized in that** the structure (H1) that mechanically withstands tensile loads in the z direction is connected to the containers (B1, B2) by a material bond.

4. Magnet arrangement according to either one of the claims 1 or 2, **characterized in that** the structure (H1) that mechanically withstands tensile loads in the z direction is connected to the containers (B1, B2) by a form-locked connection.

5. Magnet arrangement according to any one of the previous claims, **characterized in that** the coil bodies of the first coil section systems (C1, D1) and the second coil section systems (C2, D2), the structure (H1) that mechanically withstands tensile loads in the z direction and the containers (B1, B2) are made of the same material.

6. Magnet arrangement according to any one of claims 1 to 4, **characterized in that** the coil bodies of the first coil section systems (C1, D1) and the second coil section systems (C2, D2), the structure (H1) that mechanically withstands tensile loads in the z direction, and the containers (B1, B2) are made of at least two different materials.

7. Magnet arrangement according to claim 6, **characterized in that** the absolute value of the difference between the relative thermal linear expansion of at least two of the different materials on reaching an operating temperature that differs from the temperature during mechanical assembly of the magnet arrangement is less than 0.1%.

8. Magnet arrangement according to either one of the claims 6 or 7, **characterized in that** the structure (H1) that mechanically withstands tensile loads in the z direction comprises multiple segments that are arranged about the z-axis, wherein the segments are azimuthally spaced with respect to one another.

9. Magnet arrangement according to any one of the claims 6 to 8, **characterized in that** the structure (H1') that mechanically withstands tensile loads comprises at least one first, non-deformable sub-region (T1) and at least a further sub-region (T2) that is deformable in a direction perpendicular to the z axis.

10. Magnet arrangement according to any one of the previous claims, **characterized in that**, in at least one of the containers (B1, B2), at least one additional structure (F1', F2') that withstands bending loads is mechanically connected to the first coil section system (C1, D1) and to the second coil section system (C2, D2) and supports at least a part of the attractive magnetic forces (K_{C1}, K_{D1}) and of the repulsive magnetic forces (K_{C2}, K_{D2}).

11. Magnet arrangement according to any one of the previous claims, **characterized in that** at least one of the two coil section systems (C2, D2), preferably both second coil section systems (C2, D2), is radially arranged outside the corresponding first coil section system (C1, D1) and compensates in the operating state for at least 50% of the magnetic dipole moment of the first two coil section systems (C1, D1).

12. Magnet arrangement according to any one of the previous claims, **characterized in that** the coil systems (C, D) separated by the split (G) have the same mechanical and geometric structure and are positioned symmetrically with respect to the plane, that is perpendicular to the z axis and intersects it at height z=0, in the containers (B1, B2).

13. Magnet arrangement according to any one of the previous claims, **characterized in that** the coil systems (C, D) separated by the split (G) have different mechanical and geometric structures and/or are positioned asymmetrically with respect to a plane, that is perpendicular to the z axis and intersects it at height z=0, in the containers (B1, B2).

14. Magnet arrangement according to any one of the previous claims, **characterized in that** the coil section systems (C1, C2, D1, D2) are cylindrical and the inner radius (ri_{D2}, ri_{C2}) of at least one of the second coil section systems (C2, D2) is greater than 1.3 times the outer radius (ra_{D1}, ra_{C1}) of one of the first coil section systems (C1, D1).

15. Magnet arrangement according to any one of the previous claims, **characterized in that** the distance (zi_{C2}-z_{GC}, zi_{D2}-z_{GD}) between the winding package of one of the second coil section systems (C2, D2) and the split (G) is less than 12 mm.

16. Magnet arrangement according to any one of the previous claims, **characterized in that** one or more coil section systems are at least partly superconducting.

17. Magnet arrangement according to claim 16, **characterized in that** a second coil section system (C2, D2) or parts thereof and a first coil section system (C1, D1) or parts (C1a, C1b, D1a, D1b) thereof are connected in series as a protection section (A1', A2', A3', A4'), wherein the protection section (A1', A2', A3', A4') is connected in parallel with a common protection element (R1', R2', R3', R4').

18. Magnet arrangement according to claim 17, **characterized in that**, in the operating state, in at least one of the protection sections (A1', A2', A3', A4'), the magnetic dipole moments of the parts of the second coil section system (C2, D2) compensate for at least 50% of the magnetic dipole moments of the parts (C1a, C1b, D1a, D1b) of the first coil section system (C1, D1).

19. Magnet arrangement according to any one of claims 16 to 18, **characterized in that** a second coil section system (C2, D2) or parts thereof and a first coil section systems (C1, D1) or parts (C1a, C1 b, D1 a, D1b) thereof inside a superconducting current path (P1, P1', P2') are connected together in series and in parallel with a superconducting switch (S1, S1', S2').

20. Magnet arrangement according to claim 19, **characterized in that**, in the operating state in at least one of the superconducting current paths (P1, P1', P2'), the magnetic dipole moments of the parts of the second coil section system (C2, D2) compensate for at least 50% of the magnetic dipole moments of the parts (C1a, C1b, D1a, D1b) of the first coil section system (C1, D1).

21. Magnet arrangement according to any one of the previous claims, **characterized in that** the two containers (B1, B2) are filled with liquid coolants.

22. Magnet arrangement according to any one of the previous claims, **characterized in that** a device for active cooling of the containers (B1, B2) is provided.

23. Apparatus for neutron scattering, apparatus for X-ray scattering, or an MRI apparatus comprising a magnet arrangement according to any one of the previous claims.

## Revendications

1. Agencement magnétique doté d'un système de bobines magnétiques (M) pour générer un champ magnétique dans la direction d'un axe z dans un volume de travail (AV) disposé sur l'axe z autour de z=0, de deux récipients (B1, B2) disposés autour de l'axe z et de deux systèmes de bobines (C, D) disposés chacun dans l'un des récipients (B1, B2), les récipients (B1, B2) entourant chacun complètement l'un des deux systèmes de bobines et étant séparés mécaniquement l'un de l'autre axialement par rapport à l'axe z par un espace (G),
les systèmes de bobines (C, D) comprenant chacun un premier sous-système de bobines (C1, D1) et au moins l'un des systèmes de bobines (C, D) comprenant un deuxième sous-système de bobines (C2, D2), chaque sous-système de bobines (C1, C2, D1, D2) présentant au moins un corps de bobine et au moins un bobinage générateur de champ, les premiers sous-systèmes de bobines (C1, D1) étant exposés chacun, en fonctionnement, à une force magnétique résultante attractive (K_{C1}, K_{D1}) dans la direction axiale vers l'espace (G), et les deuxièmes sous-systèmes de bobines (C2, D2) étant exposés chacun, en fonctionnement, à une force magnétique résultante répulsive (K_{C2}, K_{D2}) dans la direction axiale à partir de l'espace (G), ces forces magnétiques étant transmises au moins partiellement mécaniquement aux récipients (B1, B2), et
avec au moins une structure mécanique (E, E1, E2) pouvant être sollicitée en pression, qui est disposée dans l'espace (G) et qui, en fonctionnement, absorbe au moins une partie des forces magnétiques attractives (K_{C1}, K_{D1}),
**caractérisé en ce**
**que**, dans le même espace (G) radialement, c'est-à-dire dans la direction perpendiculaire à l'axe z, à l'intérieur des dimensions des deux récipients (B1, B2), en plus de la structure mécanique (E, E1, E2) pouvant être sollicitée en pression, il est prévu une autre structure mécanique (H1) qui peut être sollicitée mécaniquement en traction dans la direction z et qui, en fonctionnement, absorbe au moins une partie des forces magnétiques répulsives dans la direction axiale (K_{C2}, K_{D2}), l'autre structure mécanique (H1) étant reliée aux deux récipients (B1, B2) et les maintenant ensemble.

2. Agencement magnétique selon la revendication 1, **caractérisé en ce que** la plus grande plage angulaire autour de l'axe z sans points de contact entre la structure (H1) pouvant être sollicitée mécaniquement en traction et les deux récipients (B1, B2) est inférieure ou égale à 180°.

3. Agencement magnétique selon l'une des revendications 1 ou 2, **caractérisé en ce que** la structure (H1) pouvant être sollicitée mécaniquement en traction dans la direction z est reliée aux récipients (B1, B2) par liaison de matière.

4. Agencement magnétique selon l'une des revendications 1 ou 2, **caractérisé en ce que** la structure (H1) pouvant être sollicitée mécaniquement en traction dans la direction z est reliée aux récipients (B1, B2) par complémentarité de forme.

5. Agencement magnétique selon l'une des revendications précédentes, **caractérisé en ce que** les corps de bobine des premiers sous-systèmes de bobines (C1, D1) et des deuxièmes sous-systèmes de bobines (C2, D2), la structure (H1) pouvant être sollicitée mécaniquement en traction dans la direction z et les récipients (B1, B2) sont constitués du même matériau.

6. Agencement magnétique selon l'une des revendications 1 à 4, **caractérisé en ce que** les corps de bobine des premiers sous-systèmes de bobines (C1, D1) et des deuxièmes sous-systèmes de bobines (C2, D2), la structure (H1) pouvant être sollicitée mécaniquement en traction dans la direction z et les récipients (B1, B2) sont constitués d'au moins deux matériaux différents.

7. Agencement magnétique selon la revendication 6, **caractérisé en ce que** la valeur absolue de la différence des variations relatives de longueur d'origine thermique d'au moins deux des matériaux différents est inférieure à 0,1 % après avoir atteint une température de fonctionnement qui est différente de la température lors du montage mécanique de l'agencement magnétique.

8. Agencement magnétique selon l'une des revendications 6 ou 7, **caractérisé en ce que** la structure (H1) pouvant être sollicitée mécaniquement en traction dans la direction z comprend une pluralité de segments qui sont disposés autour de l'axe z, les segments étant espacés azimutalement les uns des autres.

9. Agencement magnétique selon l'une des revendications 6 à 8, **caractérisé en ce que** la structure (H1') pouvant être sollicitée mécaniquement en traction comprend au moins une première zone partielle non déformable (T1) et au moins une autre zone partielle (T2) qui est déformable dans une direction perpendiculaire à l'axe z.

10. Agencement magnétique selon l'une des revendications précédentes, **caractérisé en ce qu'**au moins une structure supplémentaire (F1', F2') pouvant être sollicitée en flexion est reliée mécaniquement au premier sous-système de bobines (C1, D1) et au deuxième sous-système de bobines (C2, D2) dans au moins l'un des récipients (B1, B2) et absorbe au moins une partie des forces magnétiques attractives (K_{C1}, K_{D1}) et des forces magnétiques répulsives (K_{C2}, K_{D2}).

11. Agencement magnétique selon l'une des revendications précédentes, **caractérisé en ce qu'**au moins un des deuxièmes sous-systèmes de bobines (C2, D2), de préférence les deux deuxièmes sous-systèmes de bobines (C2, D2), sont montés radialement à l'extérieur du premier sous-système de bobines correspondant (C1, D1) et compensent au moins 50 % du moment dipolaire magnétique des deux premiers sous-systèmes de bobines (C1, D1) en fonctionnement.

12. Agencement magnétique selon l'une des revendications précédentes, **caractérisé en ce que** les systèmes de bobines (C, D) séparés par l'espace (G) ont une structure mécanique et géométrique identique et sont positionnés dans les récipients (B1, B2) symétriquement par rapport au plan qui est perpendiculaire à l'axe z et coupe celui-ci à la hauteur z=0.

13. Agencement magnétique selon l'une des revendications précédentes, **caractérisé en ce que** les systèmes de bobines (C, D) séparés par l'espace (G) ont une structure mécanique et géométrique différente et/ou sont positionnés dans les récipients (B1, B2) asymétriquement par rapport au plan qui est perpendiculaire à l'axe z et coupe celui-ci à la hauteur z=0.

14. Agencement magnétique selon l'une des revendications précédentes, **caractérisé en ce que** les sous-systèmes de bobines (C1, C2, D1, D2) sont cylindriques et le rayon intérieur (ri_{D2}, ri_{C2}) d'au moins un des deuxièmes sous-systèmes de bobines (C2, D2) est supérieur à 1,3 fois le rayon extérieur (ra_{D1}, ra_{C1}) d'un des premiers sous-systèmes de bobines (C1, D1).

15. Agencement magnétique selon l'une des revendications précédentes, **caractérisé en ce que** la distance (zi_{C2}-z_{GC}, zi_{D2}-z_{GD}) entre le bobinage d'un des deuxièmes sous-systèmes de bobines (C2, D2) et l'espace (G) est inférieure à 12 mm.

16. Agencement magnétique selon l'une des revendications précédentes, **caractérisé en ce qu'**un ou plusieurs sous-systèmes de bobines sont au moins partiellement supraconducteurs.

17. Agencement magnétique selon la revendication 16, **caractérisé en ce qu'**un deuxième sous-système de bobines (C2, D2) ou des parties de celui-ci et un premier sous-système de bobines (C1, D1) ou des parties (C1a, C1b, D1a, D1b) de celui-ci sont interconnectés en série en tant que section de protection (A1', A2', A3', A4'), la section de protection (A1', A2', A3', A4') étant connectée en parallèle avec un élément de protection commun (R1', R2', R3', R4').

18. Agencement magnétique selon la revendication 17, **caractérisé en ce que**, en fonctionnement, dans au moins une des sections de protection (A1', A2', A3', A4'), les moments dipolaires magnétiques des parties du deuxième sous-système de bobines (C2, D2) compensent à au moins 50 % les moments dipolaires magnétiques des parties (C1a, C1b, D1a, D1b) du premier sous-système de bobines (C1, D1).

19. Agencement magnétique selon l'une des revendications 16 à 18, **caractérisé en ce qu'**un deuxième sous-système de bobines (C2, D2) ou des parties de celui-ci et un premier sous-système de bobines (C1, D1) ou des parties (C1a, C1b, D1a, D1b) de celui-ci sont interconnectés en série dans un trajet de courant supraconducteur (P1, P1', P2') et connectés en parallèle avec un commutateur supraconducteur (S1, S1', S2').

20. Agencement magnétique selon la revendication 19, **caractérisé en ce que**, en fonctionnement, dans au moins un des trajets de courant supraconducteur (P1, P1', P2'), les moments dipolaires magnétiques des parties du deuxième sous-système de bobines (C2, D2) compensent à au moins 50 % les moments dipolaires magnétiques des parties (C1a, C1b, D1a, D1b) du premier sous-système de bobines (C1, D1).

21. Agencement magnétique selon l'une des revendications précédentes, **caractérisé en ce que** les deux récipients (B1, B2) sont remplis de liquides de refroidissement.

22. Agencement magnétique selon l'une des revendications précédentes, **caractérisé en ce qu'**un dispositif est prévu pour le refroidissement actif des récipients (B1, B2).

23. Appareil de diffusion des neutrons, appareil de diffusion des rayons X ou appareil d'IRM doté d'un agencement magnétique selon l'une des revendications précédentes.
